# EUROPEAN PATENT APPLICATION

(11) **EP 4 372 401 A2**
(43) Date of publication of application: **22.05.2024**
(21) Application number: 24159656.8
(22) Date of filing: 05.07.2022
(51) Int. Cl.: G01R 31/40

(54) **CHARGE/DISCHARGE TEST SYSTEM AND METHOD OF CONTROLLING CHARGE/DISCHARGE TEST SYSTEM**

(30) Priority: 07.07.2021 JP 2021112963; 25.05.2022 JP 2022085179
(62) Divisional of application: 22183030.0
(71) Applicant: Tokyo Seimitsu Co., Ltd., Hachioji-shi, Tokyo 192-8515 (JP)
(72) Inventor: YOKOYAMA, Sempei, Tokyo (JP); WATANABE, Tatsuro, Tokyo (JP); SODA, Yuya, Tokyo (JP)
(74) Representative: Grünecker Patent- und Rechtsanwälte PartG mbB

(57) **Abstract**

A charge/discharge test system (10) includes: a two-way AC/DC converter (12); a charge/discharge test device (20) that includes a DC bus (14-2), a two-way DC/DC converter (30) having one end connected to the DC bus, and a converter control unit (40); a setting unit (18) that sets a charge/discharge pattern (P1, P2) corresponding to a test charging/discharging object (28-1) serving as a target of a charge/discharge test among charging/discharging objects (28, 28-1, 28-2); and a prediction unit (44) that generates a power prediction pattern (SP) indicating a temporal change in a total value of charge and discharge power of a testing converter (30a) corresponding to the test charging/discharging object in the two-way DC/DC converter, based on the charge/discharge pattern, and the converter control unit controls charging and discharging of the charging/discharging object performed by the two-way DC/DC converter, based on the charge/discharge pattern and on the power prediction pattern.

## Description

### BACKGROUND OF THE INVENTION

### Field of the Invention

The presently disclosed subject matter relates to a charge/discharge test system that performs a charge/discharge test on a charging target, and a method of controlling the charge/discharge test system.

### Description of the Related Art

In recent years, hybrid cars, plug-in hybrid cars, and electric cars have been widely used. Development of inexpensive driving batteries is a key of the distribution of such cars. These batteries typically have capacities that are as large as several kW to several tens of kW unlike batteries for consumers, such as mobile batteries. Therefore, charging and discharging of the batteries performed at the time of development of the batteries and mass production tests require significantly large power. The power required for the charging and the discharging will further increase in the future with advancement of the distribution of cars of the aforementioned types. Also, since multiple battery cells are used in combination in the cars of the aforementioned types, a charge/discharge test system capable of testing multiple battery cells in parallel is required.

A charge/discharge test system includes, for example, a two-way alternating current (AC)/direct current (DC) converter and a plurality of two-way DC/DC converters (see Japanese Patent Application Laid-Open No. 2012-154793, for example). One end of the two-way AC/DC converter is connected to an AC power source, and the other end of the two-way AC/DC converter is connected to the plurality of two-way DC/DC converters. Also, a battery that is a target of a charge/discharge test is connected to the other end of each of the plurality of two-way DC/DC converters.

The two-way AC/DC converter converts AC power input from the AC power source into DC power and outputs the DC power to each two-way DC/DC converter. Each two-way DC/DC converter controls charging and discharging of a battery that is a target of a charge/discharge test. In a case in which a certain two-way DC/DC converter executes discharging of a battery connected to the two-way DC/DC converter, power discharged from the battery is used to charge a battery connected to another two-way DC/DC converter (hereinafter, sometimes simply referred to as the other two-way DC/DC converter) different from the two-way DC/DC converter, or is converted into regenerative power (AC regenerative power) by the two-way AC/DC converter and is then returned to the AC power source. In a case in which a certain two-way DC/DC converter performs charging of the battery connected to this two-way DC/DC converter, power that is discharged from the battery connected to the other two-way DC/DC converter and is output from the other two-way DC/DC converter is used to charge the battery connected to the two-way DC/DC converter concerned.

At this time, the charge/discharge test system described in Japanese Patent Application Laid-Open No. 2012-154793 adjusts a schedule of the charge/discharge test of the battery connected to each two-way DC/DC converter such that the regenerative power returned from the two-way AC/DC converter to the AC power source is minimized, based on a charge/discharge pattern corresponding to the battery connected to each two-way DC/DC converter set in advance. In this manner, it is possible to improve power utilization efficiency of the charge/discharge test system (to reduce a power loss).

Citation List:
Patent Literature 1: Japanese Patent Application Laid-Open No. 2012-154793

### SUMMARY OF THE INVENTION

If the schedule of the charge/discharge test of the battery connected to each two-way DC/DC converter is adjusted as in the charge/discharge test system described in Japanese Patent Application Laid-Open No. 2012-154793, it is necessary to perform a charge/discharge test of a certain battery with a time difference due to influences of charge/discharge patterns in the charge/discharge test of other batteries with respect to the certain battery. As a result, continuity of the charge/discharge tests (evaluation) of the batteries may be collapse. Also, when facilities are introduced based on prediction of a maximum number of batteries for evaluating the batteries, some converters (two-way DC/DC converters) in the facilities may be connected with no battery that is a target of a charge/discharge test due to an increase or a decrease in production volume of the batteries and a working rate of the facilities may be degraded.

The presently disclosed subject matter has been made in view of such circumstances, and an object thereof is to provide a charge/discharge test system capable of improving power utilization efficiency, improving a working rate of facilities, and securing continuity of charge/discharge tests and a method of controlling the same.

A charge/discharge test system in order to achieve the object of the presently disclosed subject matter includes: a two-way AC/DC converter that has one end connected to an alternating current power source via an AC bus, and another end connected to a first DC bus; a first charge/discharge test device that includes a second DC bus connected to the first DC bus, a plurality of first two-way DC/DC converters, each of which has one end connected to the second DC bus and another end connected to a first charging/discharging object among a plurality of first charging/discharging objects, and a first converter control unit that controls charging and discharging of the plurality of first charging/discharging objects; a setting unit that sets at least one charge/discharge pattern corresponding to at least one test charging/discharging object serving as a target of a charge/discharge test among the first charging/discharging objects; and a prediction unit that generates a power prediction pattern indicating a temporal change in a total value of charge and discharge power of at least one testing converter corresponding to the at least one test charging/discharging object in the first two-way DC/DC converters, based on the at least one charge/discharge pattern, and the first converter control unit controls charging and discharging of the first charging/discharging objects by the first two-way DC/DC converters, based on the at least one charge/discharge pattern and on the power prediction pattern.

According to the charge/discharge test system, it is possible to perform energy sharing while successively performing charge/discharge tests on a plurality of samples in accordance with each charge/discharge pattern.

The charge/discharge test system according to another aspect of the presently disclosed subject matter is configured such that, in a case in which the at least one testing converter executes the charging and discharging of the at least one test charging/discharging object in accordance with the at least one charge/discharge pattern, the first converter control unit controls the charging and discharging of at least one auxiliary charging/discharging object different from the at least one test charging/discharging object performed by at least one extra converter (indicating a converter that is not being tested, is not in operation, and is inactive. hereinafter referred to as an extra converter) different from the at least one testing converter among the first two-way DC/DC converters, based on the power prediction pattern. It is thus possible to improve power utilization efficiency.

The charge/discharge test system according to another aspect of the presently disclosed subject matter is configured such that, the first converter control unit charges the at least one auxiliary charging/discharging object, via the at least one extra converter, with power output via the second DC bus from the at least one testing converter, and charges the at least one test charging/discharging object, via the at least one testing converter, with power output from the at least one extra converter. It is thus possible to reduce a power loss.

The charge/discharge test system according to another aspect of the presently disclosed subject matter further includes a second charge/discharge test device that includes a third DC bus connected to the first DC bus, a plurality of second two-way DC/DC converters, each of which has one end connected to the third DC bus and another end connected to a second charging/discharging object among a plurality of second charging/discharging objects, and a second converter control unit that controls charging and discharging of the plurality of second charging/discharging objects; a third charge/discharge test device that includes a fourth DC bus connected to the first DC bus, a plurality of third two-way DC/DC converters, each of which has one end connected to the fourth DC bus and another end connected to a third charging/discharging object among a plurality of third charging/discharging objects, and a third converter control unit that controls charging and discharging of the plurality of third charging/discharging objects; and an integrated control unit that integrally controls the first converter control unit, the second converter control unit, and the third converter control unit, and the first converter control unit outputs power to the second charge/discharge test device and the third charge/discharge test device via the first DC bus in accordance with control by the integrated control unit, the second converter control unit outputs power to the first charge/discharge test device and the third charge/discharge test device via the first DC bus in accordance with control by the integrated control unit, and the third converter control unit outputs power to the first charge/discharge test device and the second charge/discharge test device via the first DC bus in accordance with control by the integrated control unit. It is thus possible to improve power utilization efficiency.

The charge/discharge test system according to another aspect of the presently disclosed subject matter is configured such that, in a case in which extra power exceeding a chargeable capacity of the first charging/discharging objects is generated, the first converter control unit outputs, to the integrated control unit, excess power information indicating excess power exceeding the chargeable capacity in the extra power. It is thus possible to improve power utilization efficiency.

The charge/discharge test system according to another aspect of the presently disclosed subject matter is configured such that the integrated control unit receives the excess power information and outputs, to the first charge/discharge test device, output destination information indicating the second charge/discharge test device capable of charging with the excess power, and the first converter control unit outputs the excess power to the second charge/discharge test device via the first DC bus, based on the excess power information. It is thus possible to improve power utilization efficiency.

The charge/discharge test system according to another aspect of the presently disclosed subject matter is configured such that, in a case in which the second charge/discharge test device and the third charge/discharge test device are chargeable with the excess power when the excess power information is received, the integrated control unit determines the second charge/discharge test device disposed at a distance close to the first charge/discharge test device, as an output destination of the excess power, and outputs, to the first converter control unit, output destination information indicating the second charge/discharge test device chargeable with the excess power, and the first converter control unit outputs the excess power to the second charge/discharge test device via the first DC bus, based on the excess power information and on the output destination information. It is thus possible to reduce a power loss.

The charge/discharge test system according to another aspect of the presently disclosed subject matter is configured such that, in a case in which the second charge/discharge test device and the third charge/discharge test device are not chargeable with the excess power, the integrated control unit outputs, to the first charge/discharge test device, a regeneration command for commanding output of the excess power to the two-way AC/DC converter, the first charge/discharge test device outputs the excess power to the two-way AC/DC converter, based on the regeneration command, and the two-way AC/DC converter converts the excess power into AC power and outputs the AC power to the alternating current power source. It is thus possible to reduce a power loss.

The charge/discharge test system according to another aspect of the presently disclosed subject matter is configured such that, in a case in which there is a lack of insufficient power required to charge the first charging/discharging objects, the first converter control unit outputs, to the integrated control unit, insufficient power information indicating an amount of power insufficient in the first charging/discharging objects.

The charge/discharge test system according to another aspect of the presently disclosed subject matter is configured such that the integrated control unit receives the insufficient power information, and outputs output destination information indicating the first charge/discharge test device lacking in the insufficient power, to the second charge/discharge test device capable of outputting the insufficient power, and the second converter control unit outputs the insufficient power to the first charge/discharge test device via the first DC bus, based on the insufficient power information. It is thus possible to improve power utilization efficiency.

The charge/discharge test system according to another aspect of the presently disclosed subject matter is configured such that, in a case in which the second charge/discharge test device and the third charge/discharge test device are capable of outputting the insufficient power when the insufficient power information is received, the integrated control unit determines the second charge/discharge test device disposed at a distance close to the first charge/discharge test device, as an output source, and outputs, to the second converter control unit, the output destination information indicating the first charge/discharge test device lacking in the insufficient power, and the second converter control unit outputs the insufficient power to the first charge/discharge test device via the first DC bus, based on the insufficient power information and on the output destination information. It is thus possible to improve power utilization efficiency.

The charge/discharge test system according to another aspect of the presently disclosed subject matter is configured such that the first two-way DC/DC converters include a plurality of first detectors that detect charge power at present and discharge power at present of the first charging/discharging objects, the second two-way DC/DC converters include a plurality of second detectors that detect charge power at present and discharge power at present of the second charging/discharging objects, and the third two-way DC/DC converters include a plurality of third detectors that detect charge power at present and discharge power at present of the third charging/discharging objects.

A charge/discharge test system according to another aspect of the presently disclosed subject matter includes: a two-way AC/DC converter that has one end connected to an alternating current power source via an AC bus, and another end connected to a first DC bus; and a charge/discharge test device that includes a second DC bus connected to the first DC bus, a plurality of two-way DC/DC converters, each of which has one end connected to the second DC bus and another end connected to a charging/discharging object among a plurality of charging/discharging objects, and a converter control unit that controls charging and discharging of the plurality of charging/discharging objects. It is thus possible to reduce each charge/discharge test device in size.

A method of controlling a charge/discharge test system in order to achieve the object of the presently disclosed subject matter is configured such that, the charge/discharge test system includes: a two-way AC/DC converter that has one end connected to an alternating current power source via an AC bus, and another end connected to a first DC bus; and a first charge/discharge test device that includes a second DC bus connected to the first DC bus, a plurality of first two-way DC/DC converters, each of which has one end connected to the second DC bus and another end connected to a first charging/discharging object among a plurality of first charging/discharging objects, and a first converter control unit that controls charging and discharging of the plurality of first charging/discharging objects, and the method includes: setting at least one charge/discharge pattern corresponding to at least one test charging/discharging object serving as a target of a charge/discharge test among the first charging/discharging objects; generating a power prediction pattern indicating a temporal change in a total value of charge and discharge power of at least one testing converter corresponding to the at least one test charging/discharging object in the first two-way DC/DC converters, based on the at least one charge/discharge pattern; and controlling charging and discharging of the first charging/discharging objects by the first two-way DC/DC converters, based on the at least one charge/discharge pattern and on the power prediction pattern.

The presently disclosed subject matter can realize an improvement in power utilization efficiency and an improvement in a facility working rate and securing continuity of charge/discharge tests.

### BRIEF DESCRIPTION OF THE DRAWINGS.

Fig. 1 is an overview diagram of a charge/discharge test system;
Fig. 2 is an overview diagram of the charge/discharge test system;
Fig. 3 is an overview diagram of the charge/discharge test system;
Fig. 4 is a block diagram illustrating configurations of ET devices and a main control device;
Fig. 5 is a block diagram illustrating configurations of the ET devices and the main control device;
Fig. 6 is a schematic diagram illustrating an example of a change of charge power with respect to time;
Fig. 7 is an explanatory diagram for explaining intra-rack ES;
Fig. 8 is an explanatory diagram for explaining the intra-rack ES;
Fig. 9 is an explanatory diagram for explaining the intra-rack ES;
Fig. 10 is a schematic diagram illustrating an example of a switching control method between a plurality of two-way DC/DC converters;
Fig. 11 is an explanatory diagram for explaining the inter-rack ES in a case in which excess power EX is generated;
Fig. 12 is an explanatory diagram for explaining the inter-rack ES in a case in which excess power EX is generated;
Fig. 13 is an explanatory diagram for explaining determination made by a priority determination unit regarding priority of an ET device that is an output destination of excess power EX;
Fig. 14 is a schematic diagram illustrating an example of the inter-rack ES in a case in which insufficient power LA is generated;
Fig. 15 is a schematic diagram illustrating an example of the inter-rack ES in a case in which insufficient power LA is generated;
Fig. 16 is a schematic diagram illustrating an example of the switching control method between a plurality of two-way DC/DC converters in a case in which the inter-rack ES is executed;
Fig. 17 is an explanatory diagram for explaining power regeneration;
Fig. 18 is a flowchart that corresponds to a method of controlling a charge/discharge test system according to this embodiment, and illustrates a flow of a charge/discharge test of a battery of each ET device performed by the charge/discharge test system;
Fig. 19 is a block diagram illustrating configuration examples of ET devices and a main control device according to a modified example;
Fig. 20 is a schematic diagram illustrating an example of a switching control method between a plurality of two-way DC/DC converters according to the modified example; and
Fig. 21 is an overview diagram of a charge/discharge test system according to a comparative example.

### DETAILED DESCRIPTION OF THE EMBODIMENTS

### Overall configuration of charge/discharge test system

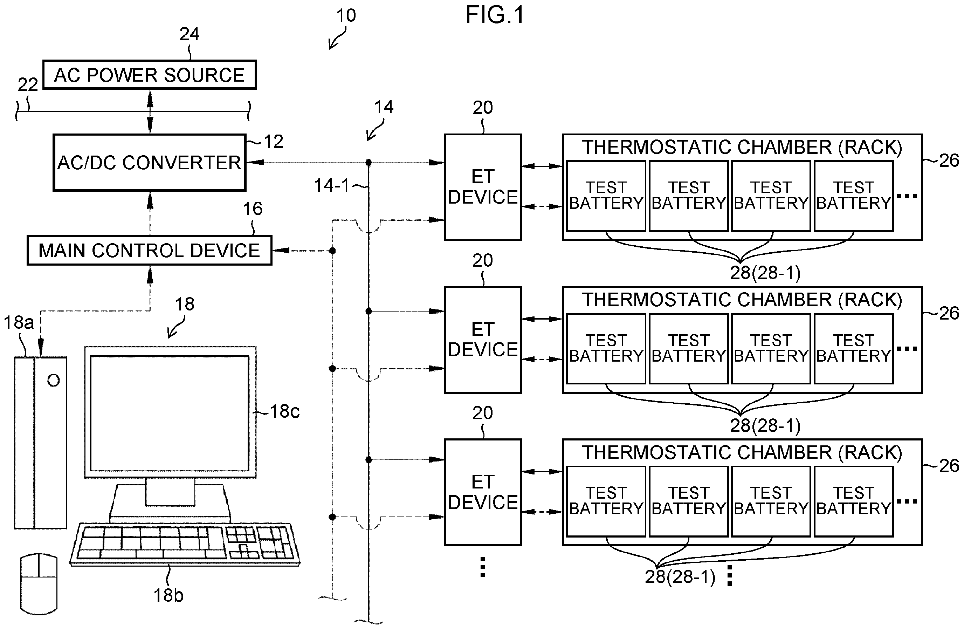

Figs. 1, 2 and 3 are overview diagrams of charge/discharge test systems 10.

The charge/discharge test system 10 can execute, in parallel, charge/discharge tests of a plurality of charging/discharging objects 28 that serve as targets of charge/discharge tests. The charging/discharging objects 28 include charging/discharging objects 28-1 that serve as targets of a charge/discharge test, and charging/discharging objects 28-2 that do not serve as targets of a charge/discharge test. The charging/discharging object 28-1 that serves as a test object, and the charging/discharging object 28-2 that does not serve as a test target are charging/discharging objects different from each other as to whether to be a battery serving as a test target or a battery not serving as a test target, for example. Note that the charging/discharging object 28-1 that serves as a test object, and the charging/discharging object 28-2 that does not serve as a test target may be different in a sense of different types of charging/discharging objects.

The charging/discharging objects 28 include batteries 28. The batteries 28 include batteries that serve as targets of a charge/discharge test (hereinafter, sometimes referred to as test batteries or samples) 28-1, and batteries that do not serve as targets of a charge/discharge test or other than targets of a charge/discharge test (hereinafter, sometimes referred to as auxiliary batteries) 28-2. The test battery 28-1 and the auxiliary battery 28-2 are batteries different from each other as to whether to be a battery serving as a test target or a battery not serving as a test target, for example.

The test battery 28-1 is a battery used by a manufacturer or the like where the charge/discharge test system 10 is installed, for example. The test batteries 28-1 are various secondary batteries such as lithium-ion batteries, nickel hydrogen batteries, and all-solid batteries (devices capable of accumulating power that include large-capacity capacitors such as electric double layers). The auxiliary batteries 28-2 are, for example, extra batteries that are not in use in a manufacturer or the like where the charge/discharge test system 10 is installed. The auxiliary batteries 28-2 may be of the same type as that of the test batteries 28-1 or may be of a different type from the test batteries 28-1.

In the example illustrated in Figs. 1 to 3, the charge/discharge test system 10 includes one two-way AC/DC converter 12 (abbreviated as an "AC/DC converter" in the drawings; the same applies to the following description), a DC bus 14, a main control device 16, a setting unit 18, and at least one ET (Energy Testing System) device (hereinafter, sometimes referred to as a charge/discharge test device) 20. The DC bus 14 includes a DC bus 14-1 that connects the two-way AC/DC converter 12 and at least one ET device 20 to each other.

One end of the two-way AC/DC converter 12 is connected to an AC bus 22. In other words, the one end of the two-way AC/DC converter 12 is connected to an AC power source 24 (alternating current power source) via the AC bus 22. The other end the opposite to the one end of the two-way AC/DC converter 12 is connected to the DC bus 14-1. In other words, the other end of the two-way AC/DC converter 12 is connected to at least one ET device 20 via the DC bus 14-1.

At the time of powering, the two-way AC/DC converter 12 converts AC power (or AC current) input from the AC power source 24 via the AC bus 22 into DC power (or DC current), and outputs the DC power to at least one ET device 20 via the DC bus 14-1. At the time of regeneration, the two-way AC/DC converter 12 converts DC power (or DC current) input from at least one ET device 20 via the DC bus 14-1 into AC power (or AC current), and returns or outputs the AC power to the AC power source 24 via the AC bus 22.

In the example illustrated in Figs. 1 to 3, one end of the DC bus 14-1 is connected to the two-way AC/DC converter 12. The other ends branched off from another end opposite to the one end of the DC bus 14-1 are connected to the respective ET devices 20.

The main control device 16 is, for example, a known control device, such as a programmable logic controller (PLC). The main control device 16 is connected to the two-way AC/DC converter 12, the setting unit 18, and each ET device 20 (e.g., an ET control unit 32, which will be described later). Note that the main control device 16 may be connected physically through wires or the like or be connectable through communication or the like, to the two-way AC/DC converter 12, the setting unit 18 and the ET devices 20. The main control device 16 controls the two-way AC/DC converter 12 and each ET device 20, based on an input command from the setting unit 18, and performs the charge/discharge test on the test battery 28-1.

The setting unit 18 may be, for example, a PC (Personal Computer), a terminal other than the PC, a mobile terminal, or a tablet. The setting unit 18 includes a main body unit 18a including various processors, a memory, and the like, an operation unit 18b such as a keyboard and a mouse, and a display unit 18c such as a display. In the setting unit 18, the main body unit 18a, the operation unit 18b and the display unit 18c may be integrated with or separated from each other. The setting unit 18 does not necessarily include the operation unit 18b or the display unit 18c.

The main body unit 18a outputs, to the main control device 16, a setting command of each charge/discharge pattern set by the operation unit 18b for each test battery 28-1 of the corresponding ET device 20. In this manner, the main control device 16 performs setting of the charge/discharge pattern of each test battery 28-1 for the corresponding ET device 20. The operation unit 18b is used for various operations of the charge/discharge test system 10 in addition to setting operations through which the charge/discharge pattern can be individually set for each test battery 28-1. The display unit 18c is used to display various kinds of information regarding the charge/discharge test system 10.

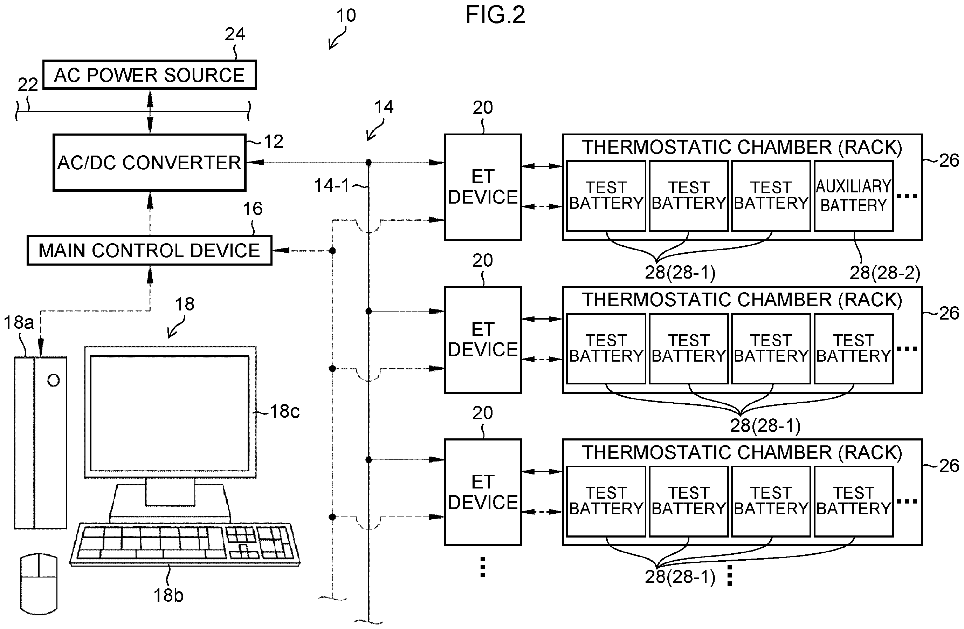

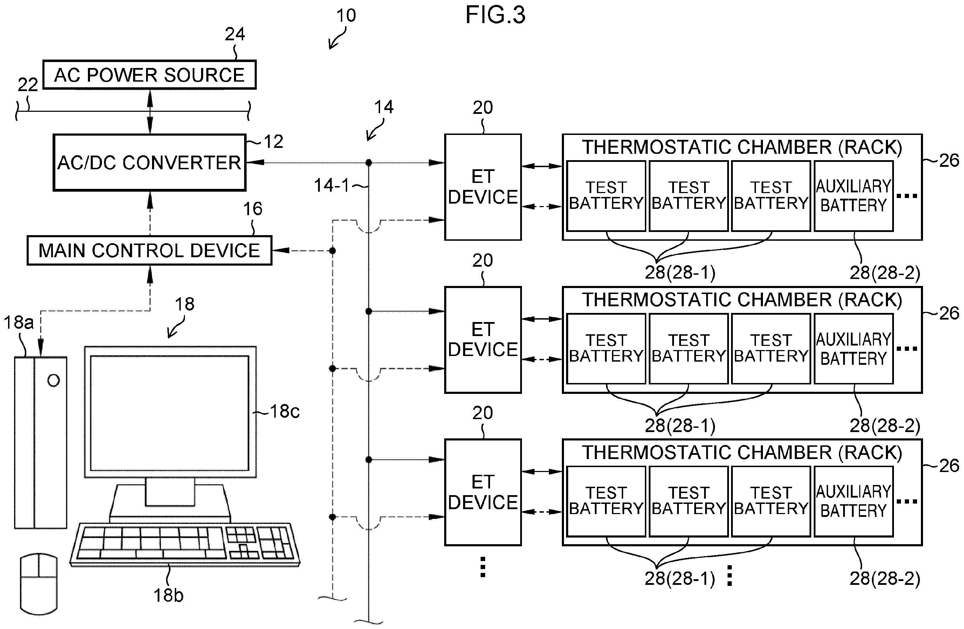

At least one ET device 20 is provided in the charge/discharge test system 10. In the example illustrated in Figs. 1 to 3, a plurality of ET devices 20 are provided in the charge/discharge test system 10. The ET devices 20 are connected to thermostatic chambers 26. In the example illustrated in Figs. 1 to 3, the ET devices 20 are respectively connected to the different thermostatic chambers 26. In other words, one ET device 20 is connected to one thermostatic chamber 26. In each thermostatic chamber 26, at least one rack where the test battery 28-1 is to be set or disposed is provided. Hereinafter, the thermostatic chamber 26 is sometimes referred to as a rack 26. Note that the auxiliary batteries 28-2 may be disposed or set out of the thermostatic chamber 26. The ET device 20 or the main control device 16 may have a function of capable of identifying whether the battery 28 disposed in the thermostatic chamber 26 is the test battery 28-1 or the auxiliary battery 28-2. The main control device 16 may have a function of capable of setting or designating whether the battery 28 connected to the thermostatic chamber 26 is the test battery 28-1 or the auxiliary battery 28-2, via the setting unit 18 (e.g., the operation unit 18b). In Fig. 2 or Fig. 3, illustration indicates that only one auxiliary battery 28-2 is disposed for one ET device 20. Alternatively, a plurality of auxiliary batteries 28-2 may be disposed for one ET device 20.

The ET device 20 executes charging and discharging (or a charge/discharge test) of each test battery 28-1 in the thermostatic chamber 26 in accordance with the charge/discharge pattern of the corresponding test battery 28-1 set by the main control device 16. In a case in which the ET device 20 executes the charge/discharge test of each test battery 28-1, the ET device 20 performs energy sharing that receives and supplies energy between the test battery 28-1 and the auxiliary battery 28-2 in the thermostatic chamber 26, between different batteries 28 in the thermostatic chamber 26 (between the test batteries 28-1, between the test battery 28-1 and the auxiliary battery 28-2, or between the auxiliary batteries 28-2), and with another ET device 20. Hereinafter, energy sharing (ES) will appropriately be abbreviated as "ES".

The ES means transmitting and receiving (or supplying and demanding) of power between the test batteries 28-1 and the auxiliary batteries 28-2, and between mutually different batteries 28, and is also referred to as power sharing. For example, this means causing other batteries 28 that can be charged to be charged with discharge power output from at least one battery 28 that performs discharging, or on the contrary, supplying charge power from other dischargeable batteries 28 to at least one battery 28 that performs charging.

In the charge/discharge test system 10 in this embodiment, it is possible to omit a two-way AC/DC conversion function from each ET device 20 at the end by providing the one integrated two-way AC/DC converter 12 in an integrated manner, and as a result, it is possible to reduce each ET device 20 in size.

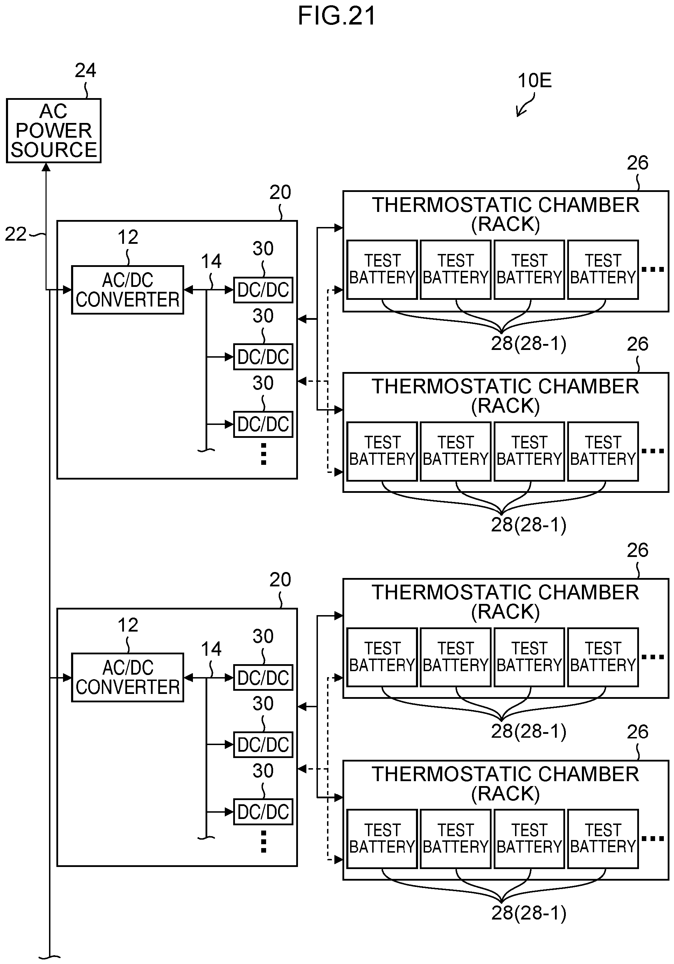

Fig. 21 is an overview diagram of a charge/discharge test system 10E according to a comparative example. Note that in Fig. 21, the two-way DC/DC converter 30 is illustrated as "DC/DC". For example, the charge/discharge test system 10E of the comparative example illustrated in Fig. 21 includes a plurality of ET devices 20 respectively including two-way AC/DC converters 12, and a plurality of thermostatic chambers 26. For example, in the charge/discharge test system 10E of the comparative example, the ET device 20 includes the two-way AC/DC converter 12, and a plurality of two-way DC/DC converters 30. Note that in the charge/discharge test system 10E, the ET device 20 may include a control device having the function of the main control device 16, and/or the setting unit 18. In the charge/discharge test system 10E of the comparative example, the plurality of two-way DC/DC converters 30 can be connected to the plurality of thermostatic chambers 26, e.g., a plurality of batteries 28 disposed in two thermostatic chambers. That is, in the charge/discharge test system 10E of the comparative example, one ET device 20 can be connected to the plurality of thermostatic chambers 26.

On the other hand, the charge/discharge test system 10 of this embodiment includes a plurality of ET devices, one two-way AC/DC converter, one setting unit, and a plurality of thermostatic chambers. For example, in the charge/discharge test system 10 in this embodiment, the plurality of two-way DC/DC converters are connected to the plurality of batteries disposed in one thermostatic chamber. That is, in the charge/discharge test system 10 in this embodiment, the ET device 20 can be connected to one thermostatic chamber.

As described above, the charge/discharge test system 10 in this embodiment can be reduced in size and can achieve space-saving in comparison with the charge/discharge test system 10 of the comparative example.

### ET control device

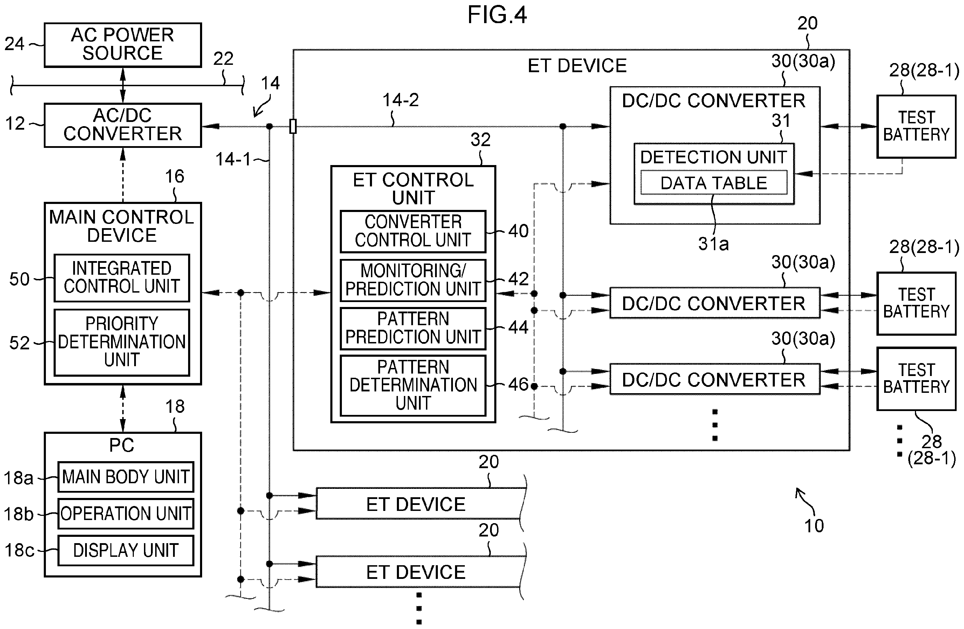

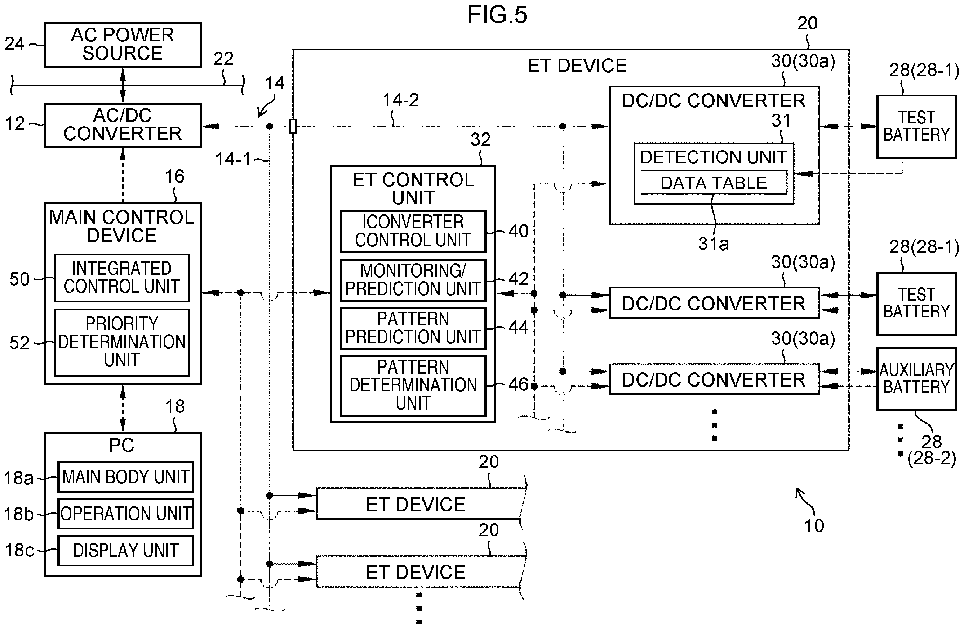

Figs. 4 and 5 are block diagrams illustrating the configurations of the ET devices 20 and the main control device 16. Note that illustration of the thermostatic chambers 26 (racks) is omitted in Figs. 4 and 5 in order to prevent complication of explanation.

As illustrated in Figs. 4 and 5, the ET device 20 includes a plurality of two-way DC/DC converters 30 (abbreviated as a "DC/DC converter" in the drawings; the same applies to the following description), an ET control unit 32, and a DC bus 14 (14-2). The DC bus 14-2 is connected to the DC bus 14-1. Note that the DC buses 14-1 and 14-2 may be formed separately from each other, or formed integrally with each other. The DC buses 14-1 and 14-2 are sometimes referred to as the DC bus 14 in an integral manner. The DC bus 14-1 or 14-2 is sometimes referred to as the DC bus 14.

One end of each two-way DC/DC converter 30 is connected to the DC bus 14-1 via the DC bus 14-2. The one end of each two-way DC/DC converter 30 is connected to the two-way AC/DC converter 12 via the DC bus 14-2 and the DC bus 14-1.

The other end opposite to the one end of each two-way DC/DC converter 30 is connected to the charging/discharging object, i.e., the battery 28 (the test battery 28-1 or the auxiliary battery 28-2). The two-way DC/DC converter 30 includes a detection unit 31. Note that the detection unit 31 may be provided separately from the two-way DC/DC converter 30. The two-way DC/DC converter 30 may be capable of identifying whether the connected charging/discharging object is the charging/discharging object 28-1 serving as a test target or the charging/discharging object 28-2 not serving as a test target. The two-way DC/DC converter 30 may be capable of identifying whether the connected battery is the test battery 28-1 or the auxiliary battery 28-2.

The two-way DC/DC converter 30 converts DC high voltage input from the DC bus 14-2 into DC low voltage with a size corresponding to the test batteries 28-1 or the auxiliary batteries 28-2, that is, lowers the voltage, and charges the test batteries 28-1 or the auxiliary batteries 28-2 at the time of powering. Conversely, the two-way DC/DC converter 30 boosts DC power output from the test batteries 28-1 or the auxiliary batteries 28-2 and then outputs the boosted DC power to another two-way DC/DC converter 30 or the two-way AC/DC converter 12 at the time of discharging (at the time of regeneration).

The two-way DC/DC converters 30 (hereinafter, sometimes referred to as "testing converters 30a") to which the test batteries 28-1 are connected among the two-way DC/DC converters 30 perform charging and discharging of the test batteries 28-1 in accordance with the charge/discharge patterns set in advance by the main control device 16 under control of the ET control units 32.

The two-way DC/DC converters 30 (hereinafter, sometimes referred to as "extra converters 30b") to which the auxiliary batteries 28-2 are connected among the two-way DC/DC converters 30 perform the ES with the testing converters 30a under control of the ET control units 32.

The detection unit 31 successively detects current power information that is information regarding current power consumption used to charge the test batteries 28-1 or the auxiliary batteries 28-2 connected to the two-way DC/DC converters 30 or current regenerative power (discharge power) discharged from the test batteries 28-1 or the auxiliary batteries 28-2. The detection unit 31 has a data table 31a (a function is also available) used to detect the current power information.

The data table 31a is information indicating correspondence of the voltage of the test batteries 28-1 or the auxiliary batteries 28-2 connected to the two-way DC/DC converters 30 and current power consumption or regenerative power and is generated by performing experiments or simulations in advance. In this manner, the detection unit 31 detects the current power consumption or the regenerative power with reference to the data table 31a based on the voltage of the batteries 28 or the auxiliary batteries 29 and outputs the current power information to the ET control unit 32 based on the detection result.

The ET control unit 32 is a known control device such as a PLC, for example, and controls charging and discharging of the test batteries 28-1 or the auxiliary batteries 28-2 performed by each two-way DC/DC converter 30. The ET control unit 32 functions as a converter control unit 40, a monitoring/prediction unit 42, a pattern prediction unit 44, and a pattern determination unit 46 through execution of a predetermined control program. The ET control unit 32 may include the converter control unit 40, the monitoring/prediction unit 42, the pattern prediction unit 44, and the pattern determination unit 46, as circuits.

The converter control unit 40 controls charging and discharging of the test batteries 28-1 or the auxiliary batteries 28-2 performed by each two-way DC/DC converter 30, based on control of the main control device 16. Specifically, the converter control unit 40 controls the charging and discharging of the test batteries 28-1 performed by all the testing converters 30a, and performs the ES between mutually different test batteries 28-1, in accordance with the charge/discharge patterns of the test batteries 28-1 set by the main control device 16. At the same time, the converter control unit 40 controls charging and discharging of the auxiliary batteries 28-2 performed by at least one extra converter 30b and performs the ES between the testing converters 30a (test batteries 28-1) and the extra converters 30b (the auxiliary batteries 28-2). Note that the converter control unit 40 may execute the ES between mutually different auxiliary batteries 28-2 by controlling charging and discharging of the auxiliary batteries 28-2 performed by at least one extra converter 30b.

The monitoring/prediction unit 42 obtains the current power information output from the detection unit 31 of each two-way DC/DC converter 30. For each testing converter 30a (the test batteries 28-1) where the corresponding charge/discharge pattern is set, the monitoring/prediction unit 42 generates prediction power information including power consumption that is power necessary to charge the corresponding test batteries 28-1 in accordance with the corresponding charge/discharge patterns, and regenerative power (discharge power) that is power discharged from the corresponding test batteries 28-1 in accordance with the corresponding charge/discharge patterns. Then, the monitoring/prediction unit 42 outputs the current power information for each two-way DC/DC converter 30 and the prediction power information for each testing converter 30a to the main control device 16. Note that in regard to the current power information, the monitoring/prediction unit 42 outputs the new current power information one by one to the main control device 16 every time the new current power information is input from the detection unit 31.

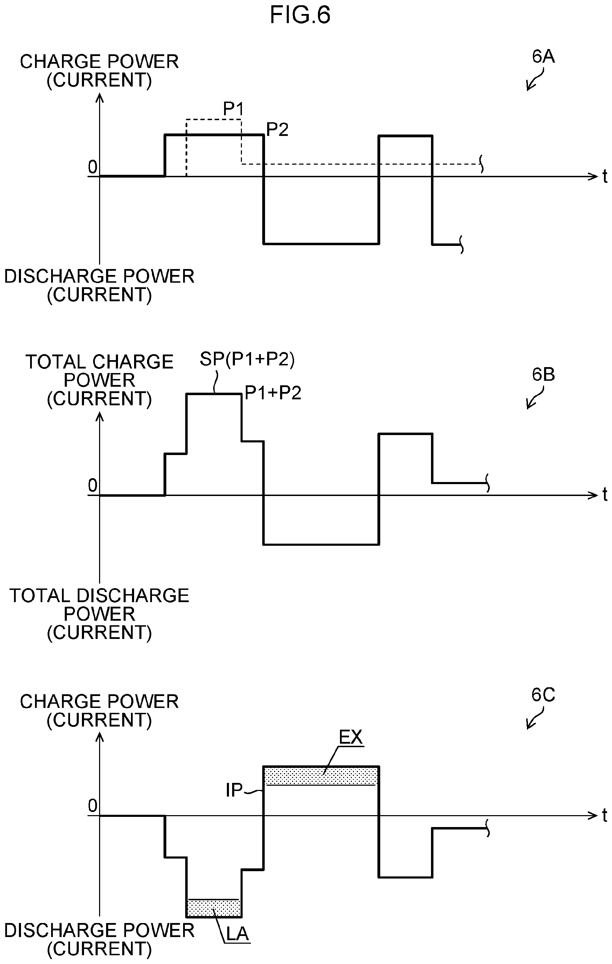

Fig. 6 is a schematic diagram illustrating an example of a change of charge power with respect to time. Note that the horizontal axis in each graph in Fig. 6 represents time. Also, the vertical axis in each graph in Fig. 6 represents charge and discharge power (charge and discharge current) or the total charge power (total charge and discharge current). On the vertical axis in Fig. 6, the distal end of each arrow indicates the positive side, and the direction opposite to the positive side indicates the negative side. With advancement on the positive side on the vertical axis in Fig. 6, the magnitude of charge power to the test batteries 28-1 or the auxiliary batteries 28-2 increases. With advancement on the negative side on the vertical axis in Fig. 6, the magnitude of discharge power discharged from the test batteries 28-1 or the auxiliary batteries 28-2 increases. In Fig. 6, it is assumed that two test batteries 28-1 are connected to two two-way DC/DC converters 30 (testing converters 30a) in a predetermined ET device 20. Note that in Fig. 6, two or more test batteries 28-1 may be connected to two or more two-way DC/DC converters 30 (testing converters 30a) in a predetermined ET device 20. The graph with the reference character 6A in Fig. 6 illustrates different two charge/discharge patterns P1 and P2 respectively corresponding to two test batteries 28-1. The graph with the reference character 6B in Fig. 6 illustrates a power prediction pattern SP corresponding to the total value of the charge/discharge patterns P1 and P2. The graph with the reference character 6C in Fig. 6 illustrates an ES pattern IP where the power prediction pattern SP is inverted with respect to an axis passing through a value at which the charge power and the discharge power are zero on the vertical axis in Fig. 6. Hereinafter, referring to Fig. 6, a method of generating the power prediction pattern SP by the pattern prediction unit 44, and a method of determining the ES pattern IP by the pattern determination unit 46 are described.

As illustrated in Figs. 4 to 6, the pattern prediction unit 44 generates the power prediction pattern SP indicating a temporal change in a total value of the charge and discharge power of each testing converter 30a inside the ET device 20 based on the charge/discharge pattern of each test battery 28-1 set for each testing converter 30a in the ET device 20.

For example, as illustrated in the graph with the reference character 6A in Fig. 6, the pattern prediction unit 44 adds the charge/discharge pattern P1 to the charge/discharge pattern P2, and generates the power prediction pattern SP as illustrated in the graph with the reference character 6B in Fig. 6. In this manner, the pattern prediction unit 44 obtains the temporal change in the total value of the charge and discharge power of each test battery 28-1. The value of the power prediction pattern SP on the positive side corresponds to the value of charge power necessary to charge the test batteries 28-1 from which the amount to be compensated by the ES between the testing converters 30a (test batteries 28-1) in the ET device 20 is removed. The value of the power prediction pattern SP on the negative side corresponds to the value of discharge power from each test battery 28-1 from which the amount of reduction by the ES between the testing converters 30a (test batteries 28-1) in the ET device 20 is removed. The pattern prediction unit 44 then outputs the power prediction pattern SP to the pattern determination unit 46.

Note that the pattern prediction unit 44 may generate the power prediction pattern SP by adding up the charge/discharge patterns of all the test batteries 28-1 connected to all the two-way DC/DC converters 30 (testing converters 30a) in the ET device 20, or generate the power prediction pattern SP using only the charge/discharge patterns of some of the test batteries 28-1 connected to all the two-way DC/DC converters 30 (testing converters 30a) in the ET device 20.

Based on the power prediction pattern SP input from the pattern prediction unit 44, the pattern determination unit 46 determines the ES pattern IP that is an inverted pattern obtained by inverting (vertically inverting in Fig. 6) the power prediction pattern SP with respect to the axis passing through the value at which the charge power and the discharge power are zero on the vertical axis in Fig. 6. It is possible to perform the ES of covering the charge power necessary to charge at least one test battery 28-1 or at least one auxiliary battery 28-2 with the charge power of at least one test battery 28-1 or at least one auxiliary battery 28-2, and of charging at least one test battery 28-1 or at least one auxiliary battery 28-2 with the discharge power from at least one test battery 28-1 or at least one auxiliary battery 28-2, by causing at least one test battery 28-1 or at least one auxiliary battery 28-2 to be charged and discharged within a range in which the chargeable capacity and the dischargeable capacity thereof are not exceeded in accordance with this ES pattern IP. At this time, the reference character LA in the graph with the reference character 6C in Fig. 6 designates insufficient power corresponding to an insufficient part of charge power of all or some of the auxiliary batteries 28-2 with respect to the charge power necessary to charge all or some of the test batteries 28-1 in the thermostatic chamber 26. Also, the reference character EX in the graph 6C in Fig. 6 designates excess power exceeding the chargeable capacity (total value) of all or some of the auxiliary batteries 28-2, in the discharge power (total value) discharged from the test batteries 28-1 inside the thermostatic chamber 26.

### Main control device

The main control device 16 includes an integrated control unit 50, and a priority determination unit 52. The main control device 16 functions as the integrated control unit 50 and the priority determination unit 52 by executing predetermined control programs. Note that the main control device 16 may include the integrated control unit 50 and the priority determination unit 52 as circuits.

The integrated control unit 50 performs integrated control on the ET control unit 32 of each ET device 20. The integrated control unit 50 outputs, to each ET device 20, a setting command for the charge/discharge pattern of each test battery 28-1 input from the setting unit 18. In this manner, the charge/discharge tests of the test batteries 28-1 in accordance with the charge/discharge patterns are executed by at least one testing converter 30a for each ET device 20. Also, at this time, the integrated control unit 50 performs the control of the ES between mutually different ET devices 20 and causes power regeneration of the extra part of the excess power EX that exceeds charge capacity even through the ES to be performed.

Furthermore, the integrated control unit 50 outputs the current power information and the prediction power information input from the monitoring/prediction unit 42 of each ET device 20 to the setting unit 18 (e.g., the main body unit 18a). In a case in which the setting unit 18 receives the current power information and the prediction power information from each ET device 20, the setting unit 18 can cause the display unit 18c to display the current power information and the prediction power information on each ET device 20 for the corresponding ET device 20, or cause the display unit 18c to display the current power information and the prediction power information as together.

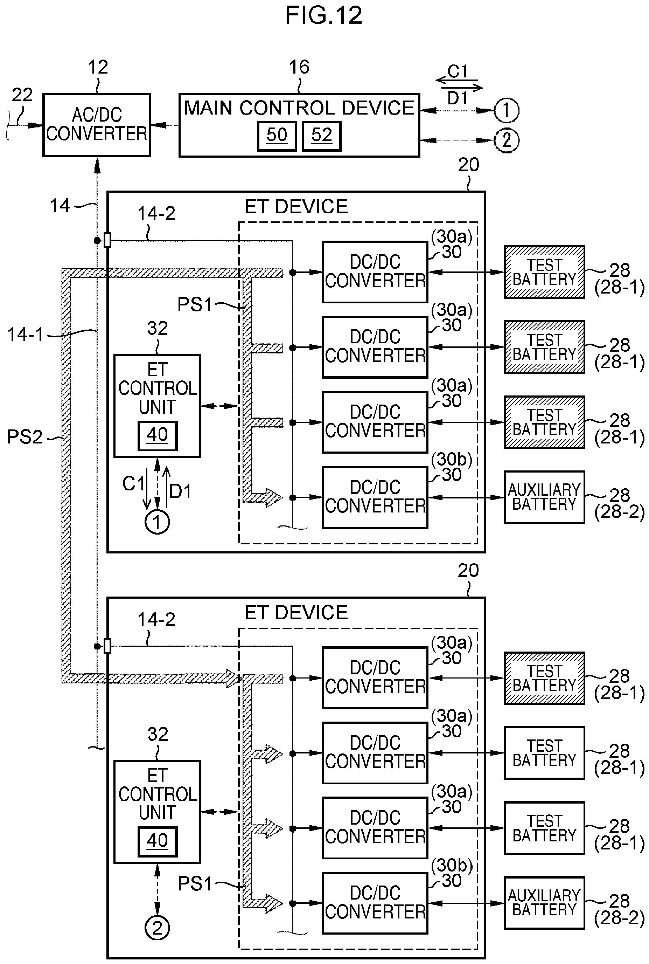

The priority determination unit 52 operates in a case in which it is necessary to perform ES (inter-rack ES, which will be described later) between the test batteries 28-1 or between the test batteries 28-1 and the auxiliary batteries 28-2 disposed or set in mutually different thermostatic chambers (racks) 26 and determines priority of the ET devices 20 on which the inter-rack ES is to be performed, as will be described later in detail (see Fig. 12).

### ES

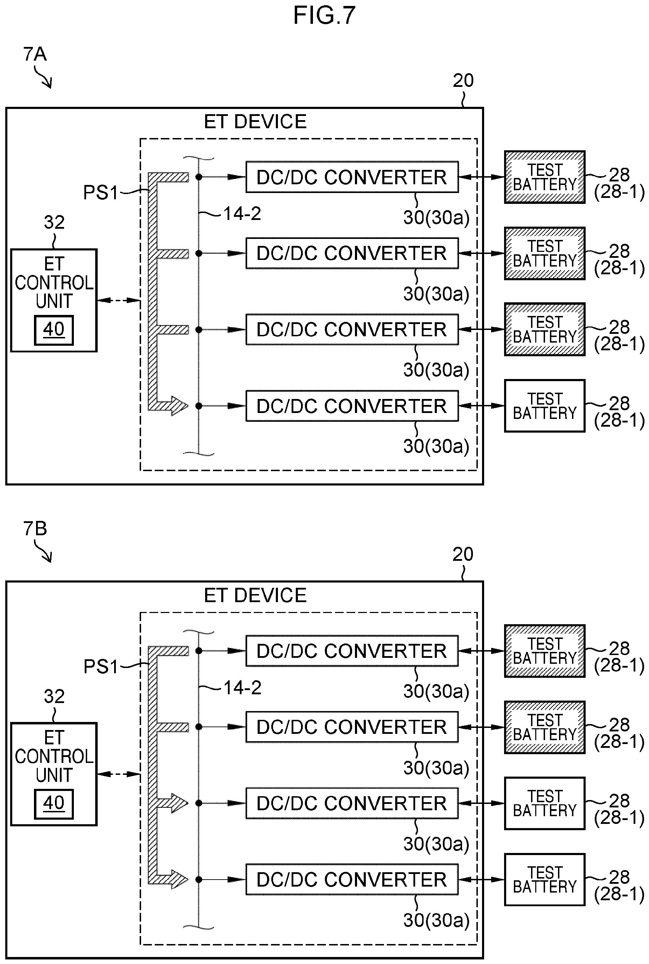

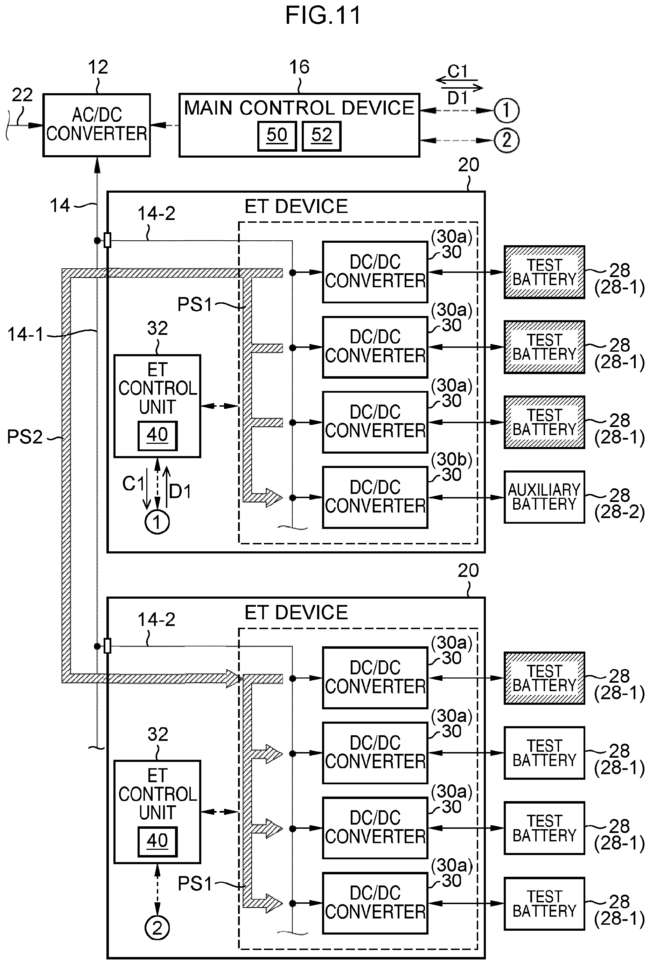

Next, the ES performed during the charge/discharge test will be specifically described. The ES performed during the charge/discharge test includes intra-rack ES (see Figs. 7 to 10) and inter-rack ES (see Figs. 11 to 16).

### <Intra-rack ES>

Figs. 7 to 9 are explanatory diagrams for explaining intra-rack ES. Note that in Figs. 7 to 9, the test batteries 28-1 and the auxiliary batteries 28-2 during discharging among the test batteries 28-1 and the auxiliary batteries 28-2 that perform charging and discharging are displayed with oblique lines (the same applies to Fig. 11 and the following drawings). Also, in Figs. 7 to 9, flows of power (current) inside the intra-rack ES are represented with the arrow PS1.

As illustrated in Figs. 7 to 9, the ET device 20 executes the intra-rack ES during the charge/discharge test. The converter control unit 40 of each ET device 20 constantly executes the intra-rack ES when the charging and the discharging of the test batteries 28-1 are performed in accordance with the charge/discharge pattern set in advance for each testing converter 30a (test battery 28-1 which is connected thereto). The intra-rack ES includes "ES between test batteries (Inter-test battery ES)" that is ES between mutually different test batteries 28-1 inside the same thermostatic chamber 26 (rack) and "ES between the test batteries and the auxiliary batteries" that is ES between the test batteries 28-1 and the auxiliary batteries 28-2 in the same thermostatic chamber 26. Note that the intra-rack ES may encompass "ES between auxiliary batteries" which is ES between different auxiliary batteries 28-2 in the same thermostatic chamber 26.

### (ES between test batteries)

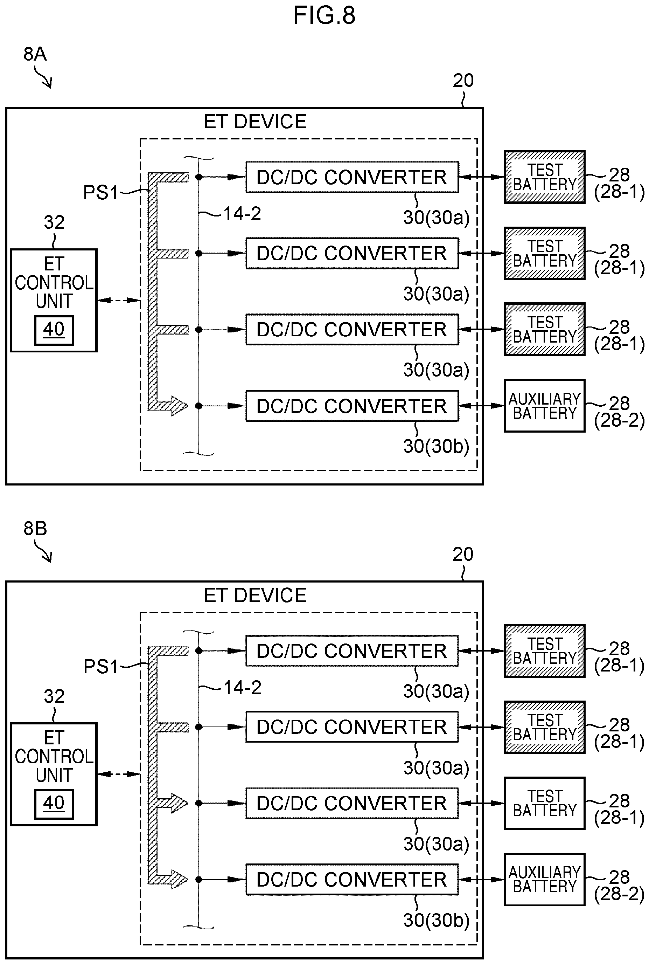

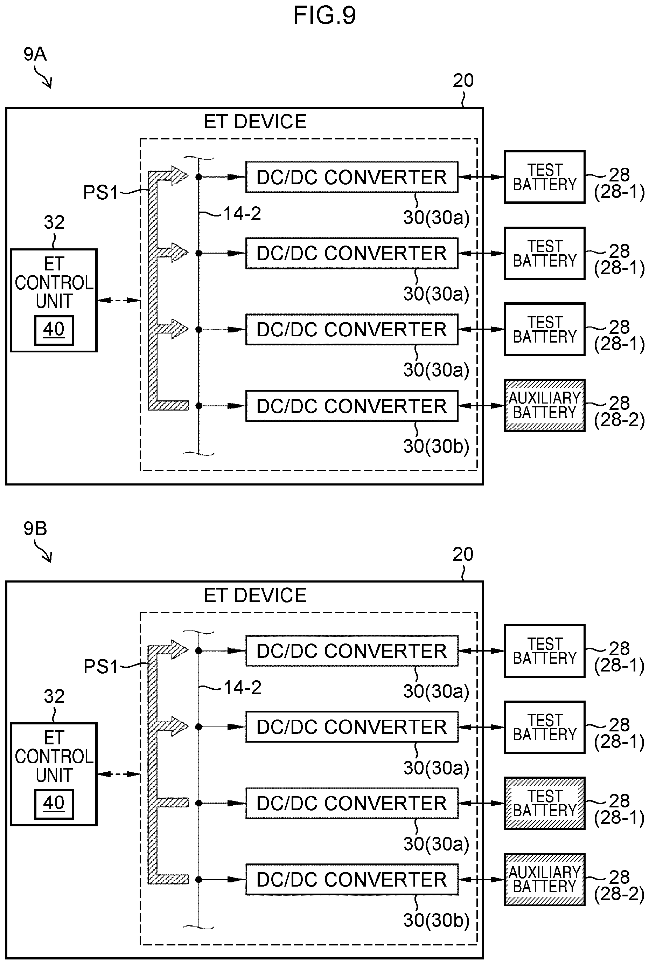

Specifically, in a case in which the discharging from predetermined test batteries 28-1 and charging of test batteries 28-1 different from the predetermined test batteries 28-1 are performed at the same timing by two or more mutually different testing converters 30a based on the charge/discharge pattern corresponding to each test batteries 28-1 connected to each testing converter 30a, the converter control unit 40 outputs the discharge power output from the testing converters 30a during discharging to the testing converters 30a during charging via the DC bus 14-2. In this manner, the ES between test batteries using the discharge power output from the testing converters 30a during discharging as charge power of the test batteries 28-1 by the testing converters 30a during charging is performed (see reference characters 7A and 7B in Fig. 7, reference character 8B in Fig. 8, and reference character 9B in Fig. 9). Note that in a case in which the discharging from the test batteries 28-1 and the charging of the test batteries 28-1 are not performed at the same timing by the two or more testing converters 30a, the ES between test batteries is not executed, and only the ES between test batteries and auxiliary batteries, which will be described later, is executed (see reference character 8A in Fig. 8, and reference character 9A in Fig. 9).

### (ES between test batteries and auxiliary batteries)

The converter control unit 40 controls charging and discharging of the auxiliary batteries 28-2 performed by the extra converters 30b inside the ET device 20 based on the ES pattern IP determined by the pattern determination unit 46 and causes each extra converter 30b to charge or discharge each auxiliary battery 28-2 within a range in which the chargeable capacity and the dischargeable capacity thereof are not exceeded. In this manner, the ES between test batteries and auxiliary batteries of causing the extra converters 30b to charge the auxiliary batteries 28-2 with discharge power output from the testing converters 30a during discharging as illustrated in reference character 8A in Fig. 8 or outputting the charge power, with which the auxiliary batteries 28-2 have been charged, to the testing converters 30a during charging as illustrated in reference characters 9A and 9B in Fig. 9 is executed. Note that although not illustrated, the converter control unit 40 may execute the ES between auxiliary batteries that controls charging and discharging of predetermined auxiliary batteries 28-2 by a predetermined extra converter 30b in a predetermined thermostatic chamber 26 to charge the auxiliary batteries 28-2 with discharge power output from the extra converter 30b during discharging, and output charge power charged in the auxiliary batteries 28-2 to the extra converter 30b during charging.

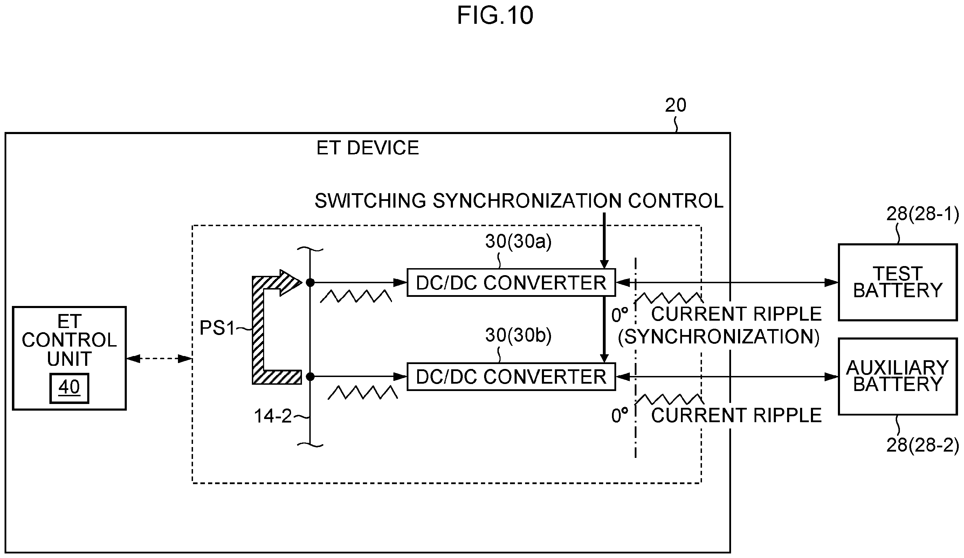

Fig. 10 is a schematic diagram illustrating an example of a switching control method between a plurality of two-way DC/DC converters. In Fig. 10, the flow of power (current) inside the intra-rack ES is represented with an arrow PS1.

The converter control unit 40 can synchronize switching control of charging and discharging between the two-way DC/DC converters 30. Note that the converter control unit 40 may synchronize switching control of charging and discharging between the two-way DC/DC converters in accordance with the command of the main control device 16. The converter control unit 40 does not necessarily synchronize switching control of charging and discharging between the two-way DC/DC converters 30.

In the example illustrated in Fig. 10, in a case in which the converter control unit 40 executes the ES between test batteries and auxiliary batteries during the charge/discharge test, in the ET device 20 the converter control unit 40 controls discharging of the auxiliary battery 28-2 by the extra converters 30b, and charges the test battery 28-1 with the discharge power discharged from the auxiliary battery 28-2 via the testing converters 30a. At this time, in the ET device 20, the converter control unit 40 synchronizes switching control of discharging of the auxiliary battery 28-2 by the extra converter 30b with switching control of charging of the test battery 28-1 by the testing converter 30a. It is thus possible to synchronize the current ripple of current discharged from the auxiliary battery 28-2 with the current ripple of current with which the test battery 28-1 is charged, by synchronizing switching control of discharging of the auxiliary battery 28-2 by the extra converter 30b with switching control of charging of the test battery 28-1 by the testing converter 30a. Accordingly, by synchronizing the switching control of discharging of the auxiliary battery 28-2 with the switching control of charging of the test battery 28-1 by the extra converter 30b, the output current ripple can be reduced. By reducing the output current ripple, reduction in loss, reduction in cable heat generation, and long operating lives of fuses can be achieved.

Note that with reference to Fig. 10, the case of execution of the ES between test batteries and auxiliary batteries is described. Also, in a case of execution of the ES between test batteries, switching control of the two-way DC/DC converters 30 may be synchronized so as to synchronize the periods of current ripples corresponding to the respective two-way DC/DC converters 30. Also, in the case of execution of the ES between auxiliary batteries, switching control of the two-way DC/DC converters 30 may be synchronized so as to synchronize the periods of current ripples corresponding to the respective two-way DC/DC converters 30.

### <ES between racks (Inter-rack ES)>

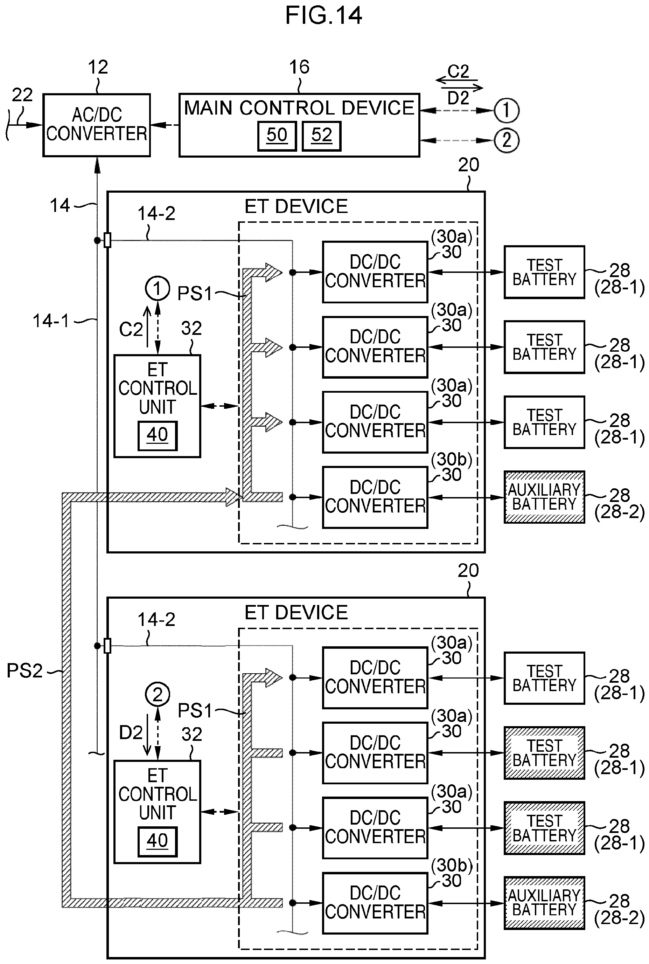

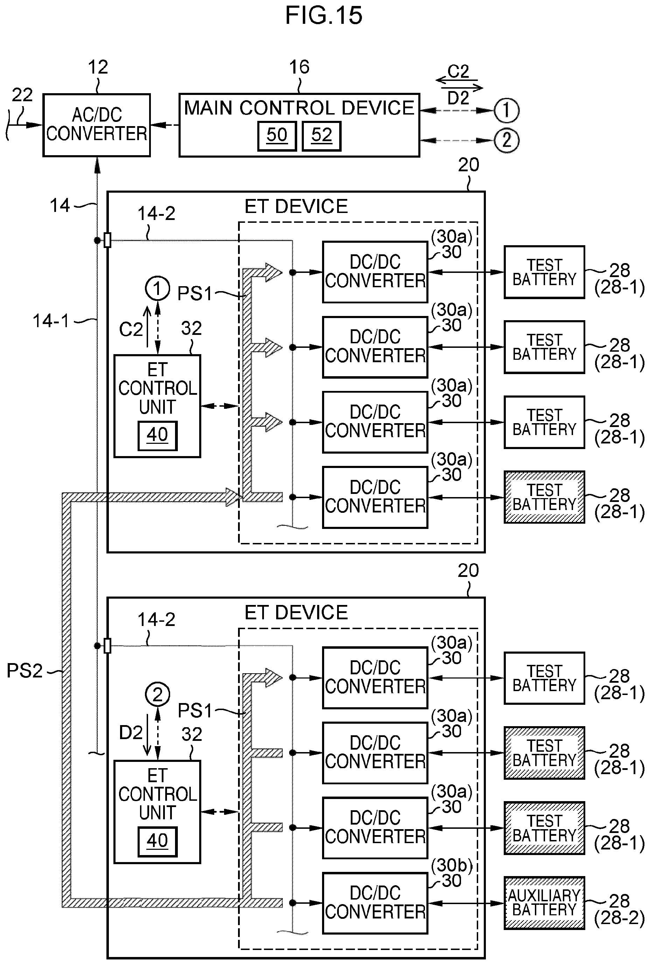

Figs. 11 and 12 are explanatory diagrams for explaining inter-rack ES in a case in which excess power EX is generated. The inter-rack ES is energy sharing performed across the plurality of ET devices 20, and the excess power EX that exceeds charge capacity of the auxiliary batteries 28-2 in the intra-rack ES for each ET device 20 is output to other ET device 20 via the DC buses 14-1 and 14-2, or insufficient power LA that cannot be covered from the auxiliary batteries 28-2 (or test batteries 28-1) in the intra-rack ES is covered by other ET devices 20 via the DC buses 14-1 and 14-2. Note that in Figs. 11 and 12 (the same also applies to Figs. 14 and 15, which will be described later), a flow of power (current) in the inter-rack ES is represented by the arrow PS2. As illustrated in Figs. 11 and 12, in the intra-rack ES in this embodiment, power (or DC current) between the batteries 28 can be transmitted by the two-way DC/DC converters 30 via the DC buses 14-1 and 14-2. Consequently, power conversion, for example, AC/DC conversion and the like can be reduced. According to the intra-rack ES in this embodiment, the energy or power loss can be reduced.

As illustrated in Figs. 11 and 12, in a case in which the excess power EX that exceeds the charge capacity of the auxiliary battery 28-2 (or test batteries 28-1) in the intra-rack ES is generated based on the ES pattern IP determined by the pattern determination unit 46, the converter control unit 40 outputs excess power information C1 indicating the amount of excess power EX to the integrated control unit 50.

The integrated control unit 50 searches for another ET device 20 capable of charging the auxiliary batteries 29 (batteries 28 are also available) with the excess power EX with reference to the current power information and the power prediction pattern SP (ES pattern IP) of each ET device 20 based on the excess power information C1 input from the converter control unit 40. Then, in a case in which a plurality of ET devices 20 have been searched for, the integrated control unit 50 determines the ET device 20 as an output destination of the excess power EX in accordance with priority determined by the priority determination unit 52, which will be described later.

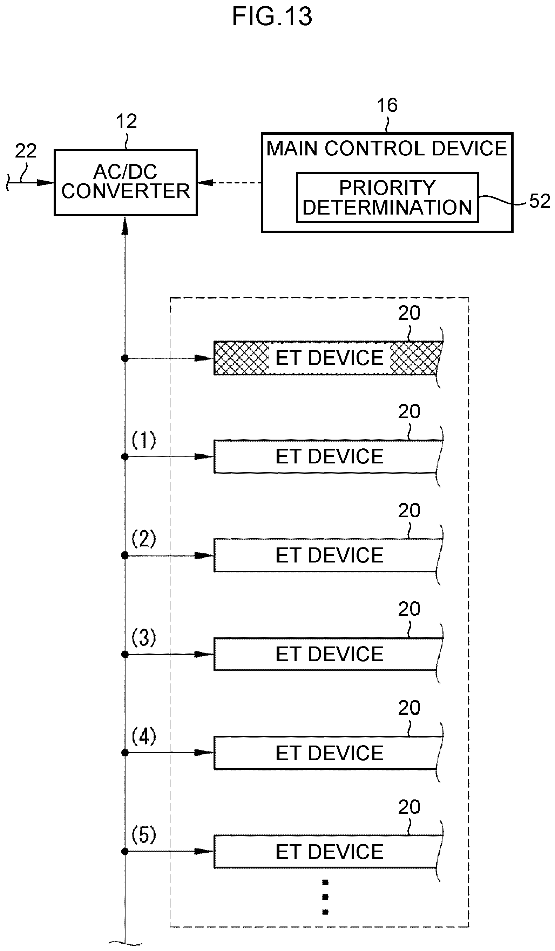

Fig. 13 is an explanatory diagram for explaining determination of priority of the ET devices 20 as the output destination of the excess power EX performed by the priority determination unit 52. Note that in Fig. 13, the ET device 20 that is a transmission source of the excess power information C1 is represented with hatching, and all other ET devices 20 are assumed to be able to perform charging with the excess power EX.

As illustrated in Fig. 13, in the case in which the integrated control unit 50 searches for a plurality of ET devices 20 capable of performing charging with the excess power EX, the priority determination unit 52 determines priority of the ET devices 20 such that the ET devices 20 at positions closer to the ET device 20 serving as the transmission source of the excess power information C1 are determined as the output destination of the excess power EX with higher priority as represented by the numbers in brackets (1), (2), .... The loss of the excess power EX until the excess power EX is input to the ET device 20 that is the output destination increases as the distance between ET device 20 that is the transmission source of the excess power information C 1 (or the two-way DC/DC converter 30 or the battery 28) and the ET device 20 that is the output destination of the excess power EX (or the two-way DC/DC converter 30 or the battery 28), for example, the length of the wire connecting the transmission source ET device 20 to the output destination ET device 20, or the physical distance between the transmission source ET device 20 and the output destination ET device 20 increases, and on the contrary, the loss of the excess power EX until the excess power EX is input to the output destination ET device 20 decreases as the distance decreases. Therefore, the loss of the excess power EX is reduced by determining the ET devices 20 at the distance closer to the ET device 20 that is the transmission source of the excess power information C1 as the ET device 20 that is the output destination of the excess power EX with higher priority.

Returning to Figs. 11 and 12, in a case in which the number of other ET devices 20 capable of charging with the excess power EX is one, the integrated control unit 50 outputs first output destination information D1 indicating the ET device 20 to the converter control unit 40 of the ET device 20 as the transmission source of the excess power information C1. Also, in a case in which a plurality of other ET devices 20 can perform charging with the excess power EX, the integrated control unit 50 determines the ET devices 20 as output destinations of the excess power EX in accordance with the priority determined by the priority determination unit 52 and outputs the first output destination information D1 indicating all the determined ET devices 20 to the converter control unit 40 of the ET device 20 as the transmission source of the excess power information C1.

The converter control unit 40 that has received an input of the first output destination information D1 controls at least one testing converter 30a during discharging and causes the testing converters 30a to output the excess power EX to all or some of the ET devices 20 corresponding to the first output destination information D1. The converter control units 40 of the ET devices 20 that have received an input of the excess power EX control at least one extra converter 30b and causes the auxiliary battery 28-2 to be charged with the excess power EX, or controls at least one testing converter 30a during charging and causes the test batteries 28-1 to be charged with the excess power EX. In this manner, it is possible to cause other ET devices 20 to charge the test batteries 28-1 and/or the auxiliary batteries 28-2 with the excess power EX that exceeds the charge capacity of the test batteries 28-1 and/or the auxiliary batteries 28-2 in the intra-rack ES in a certain ET device 20.

Figs. 14 and 15 are schematic diagrams illustrating an example of inter-rack ES in a case in which insufficient power LA is generated. As illustrated in Figs. 14 and 15, in a case in which the insufficient power LA that cannot be covered by the test batteries 28-1 and/or the auxiliary batteries 28-2 in the intra-rack ES occurs based on the ES pattern IP determined by the pattern determination unit 46, the converter control unit 40 outputs insufficient power information C2 indicating the amount of insufficient power LA to the integrated control unit 50.

The integrated control unit 50 searches for other ET devices 20 capable of outputting power corresponding to the insufficient power LA incapable of coverage from the test batteries 28-1 and/or the auxiliary batteries 28-2 with reference to the current power information and the power prediction pattern SP (ES pattern IP) of each ET device 20 based on the insufficient power information C2 input from the converter control unit 40.

If the integrated control unit 50 searches for a plurality of ET devices 20 capable of outputting the insufficient power LA at this time, the priority determination unit 52 determines priority of the ET devices 20 such that the ET devices 20 at the distance closer to the ET device 20 that is the transmission source of the insufficient power information C2 are determined as ET devices 20 that are output sources of the insufficient power LA with higher priority, in a similar manner to the case when the excess power EX occurs as illustrated in Fig. 13 which has already been described above. It is possible to reduce a loss of the insufficient power LA by determining the ET devices 20 at the distance closer to the ET device 20 that is the transmission source of the insufficient power information C2 as the ET device 20 that is the output source of the insufficient power LA with higher priority.

In a case in which the number of other ET devices 20 capable of outputting the insufficient power LA is one, the integrated control unit 50 outputs, to the ET device 20, second output destination information D2 indicating the ET device 20 that is the transmission source of the insufficient power information C2 as the ET device 20 that is the output destination of the insufficient power LA. Also, in a case in which a plurality of other ET devices 20 capable of outputting the insufficient power LA are present, the integrated control unit 50 determines the ET devices 20 as output sources of the insufficient power LA in accordance with the priority determined by the priority determination unit 52 and outputs the second output destination information D2 to all the determined ET devices 20.

The converter control units 40 of all the ET devices 20 that have received an input of the second output destination information D2 control at least one two-way DC/DC converter 30 (the testing converters 30a and/or the extra converters 30b) and cause the two-way DC/DC converters 30 to output charge power, with which the test batteries 28-1 and/or auxiliary batteries 28-2 have been charged, as the insufficient power LA, to the ET devices 20 indicated by the second output destination information D2. The converter control units 40 of the ET devices 20 that have received an input of the insufficient power LA control at least one testing converter 30a and/or at least one extra converter 30b and cause the test batteries 28-1 and/or auxiliary batteries 28-2 to be charged with the insufficient power LA. In this manner, it is possible to cover the insufficient power LA, which cannot be covered from the test batteries 28-1 and/or auxiliary batteries 28-2 even in the intra-rack ES in a certain ET device 20, with other ET devices 20.

The converter control unit 40 controls at least one extra converter 30b and causes the auxiliary battery 28-2 to be charged, or controls at least one testing converter 30a during charging and causes the test batteries 28-1 to be charged. In this manner, it is possible to cause other ET devices 20 to charge the test batteries 28-1 and/or the auxiliary batteries 28-2 with the excess power EX that exceeds the charge capacity of the test batteries 28-1 and/or the auxiliary batteries 28-2 in the intra-rack ES in a certain ET device 20.

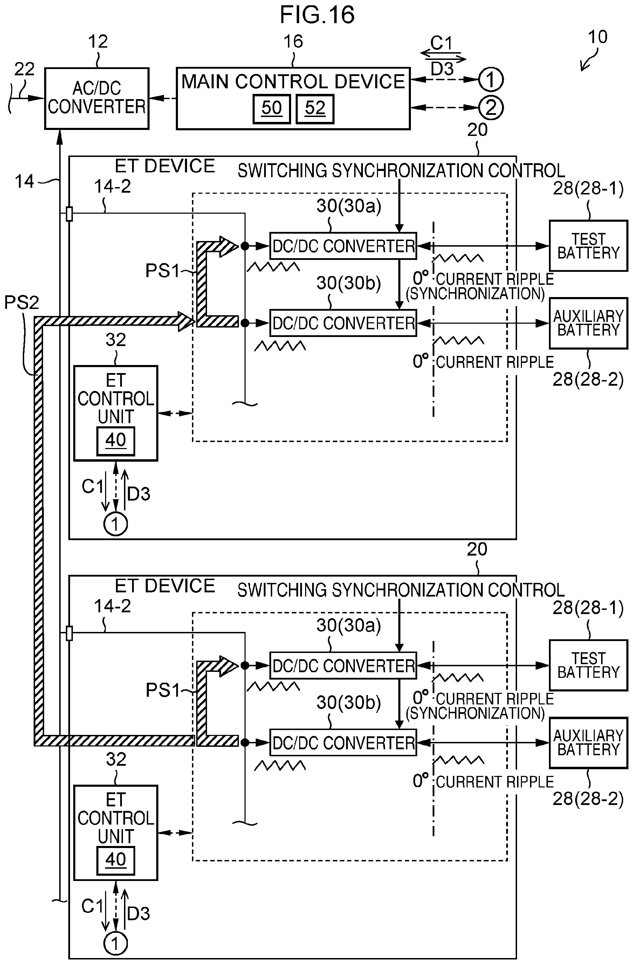

Fig. 16 is a schematic diagram illustrating an example of a switching control method between a plurality of two-way DC/DC converters in a case in which inter-rack ES is executed. In Fig. 16, the flow of power (current) inside the inter-rack ES is represented with an arrow PS2.

The converter control unit 40 can synchronize switching control of charging and discharging between at least one two-way DC/DC converter 30 in a predetermined ET device 20 and at least one two-way DC/DC converter 30 of another ET device 20 different from the predetermined ET device 20. Note that the converter control unit 40 may synchronize switching control of charging and discharging between at least one two-way DC/DC converter 30 in the predetermined ET device 20 and at least one two-way DC/DC converter 30 of the other ET device 20 different from the predetermined ET device 20 in accordance with a command of the main control device 16. Note that the converter control unit 40 does not necessarily synchronize switching control of charging and discharging between at least one two-way DC/DC converter 30 in the predetermined ET device 20 and at least one two-way DC/DC converter 30 of the other ET device 20 different from the predetermined ET device 20.

In the example illustrated in Fig. 16, in a case of execution of the inter-rack ES during the charge/discharge test, the converter control unit 40 controls discharging of at least one auxiliary battery 28-2 by at least one extra converter 30b in a predetermined ET device 20, and charges at least one test battery 28-1 with discharge power discharged from at least one auxiliary battery 28-2 in another ET device 20 via at least one testing converter 30a. At this time, the converter control unit 40 synchronizes switching control of discharging of at least one auxiliary battery 28-2 by at least one extra converter 30b in the predetermined ET device 20 with switching control of charging of at least one test battery 28-1 by at least one testing converter 30a. It is thus possible to synchronize the current ripple of current discharged by at least one auxiliary battery 28-2 in a predetermined ET device 20 with the current ripple of current with which at least one test battery 28-1 in another ET device 20 is charged, by synchronizing switching control of discharging of at least one auxiliary battery 28-2 by at least one extra converter 30b in the predetermined ET device 20 with switching control of charging of at least one test battery 28-1 by at least one testing converter 30a in the other ET device 20. It is thus possible to reduce the output current ripple by synchronizing switching control of discharging of at least one auxiliary battery 28-2 by at least one extra converter 30b in the predetermined ET device 20 with switching control of charging of at least one test battery 28-1 by at least one testing converter 30a in the other ET device 20. By reducing the output current ripple, reduction in loss, reduction in cable heat generation, and long operating lives of fuses can be achieved.

Note that with reference to Fig. 16, the example is described where during execution of the inter-rack ES, switching control of discharging of at least one auxiliary battery 28-2 by at least one extra converter 30b in the predetermined ET device 20 is synchronized with switching control of charging of at least one test battery 28-1 by at least one testing converters 30a in the other ET device 20. Alternatively, during execution of the inter-rack ES, switching control of at least one test battery 28-1 by at least one testing converter 30a in the predetermined ET device 20 may be synchronized with switching control of charging of at least one test battery 28-1 by at least one testing converter 30a in the other ET device 20.

### Power regeneration

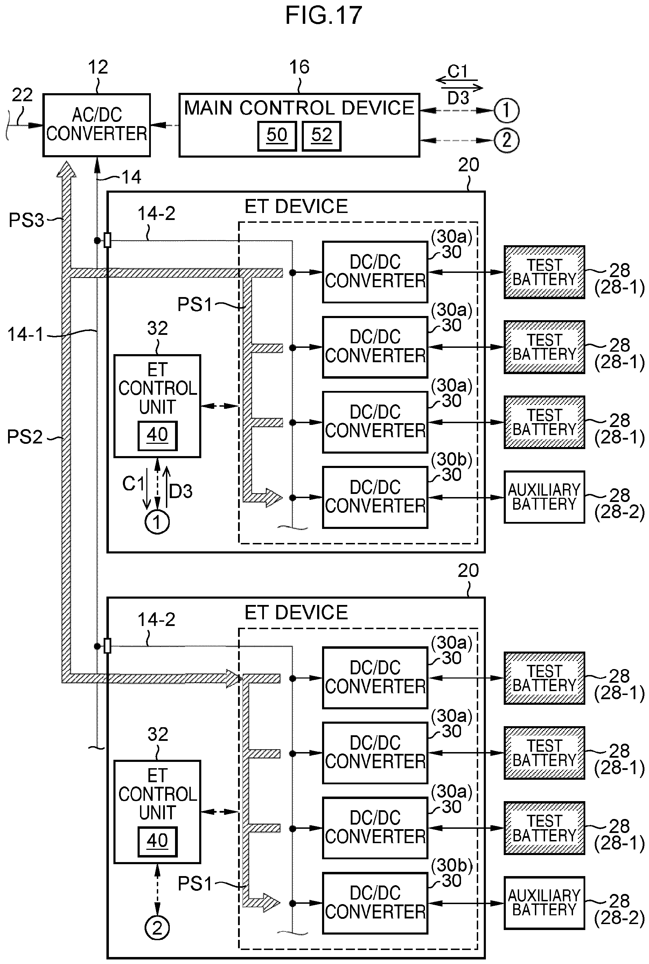

Fig. 17 is an explanatory diagram for explaining power regeneration. Note that in Fig. 17, a flow of power (current) in the power regeneration is represented by the arrow PS3. As illustrated in Fig. 17, the power regeneration is a process of converting the extra part of the excess power EX that exceeds the charge capacity of both the intra-rack ES and the inter-rack ES into AC power using the two-way AC/DC converter 12 and returns the converted power to the AC power source 24.

Although the integrated control unit 50 searches for other ET devices 20 capable of performing charging with the excess power EX with reference to the current power information and the power prediction pattern SP of each ET device 20 based on the excess power information C1 input from the converter control unit 40, the integrated control unit 50 starts the power regeneration of the extra part of the excess power EX in a case in which no ET devices 20 capable of performing charging with all the excess power EX have been searched for. In this case, the integrated control unit 50 outputs the regeneration command D3 to the converter control unit 40 of the ET device 20 as the transmission source of the excess power information C1.

The converter control unit 40 that has received the regeneration command D3 controls at least one testing converters 30a (or extra converter 20b) and outputs the extra part of the excess power EX that exceeds the charge capacity of both the intra-rack ES and the inter-rack ES to the two-way AC/DC converter 12.

The two-way AC/DC converter 12 executes the power regeneration of converting the excess power EX input from at least one testing converter 30a (or extra converter 20b) into regenerative power and then returning the regenerative power to the AC power source 24. In this manner, it is possible to convert only the extra part of the excess power EX that exceeds the charge capacity of the ES into AC power and to return the AC power to the AC power source 24.

### Effects of charge/discharge test system 10

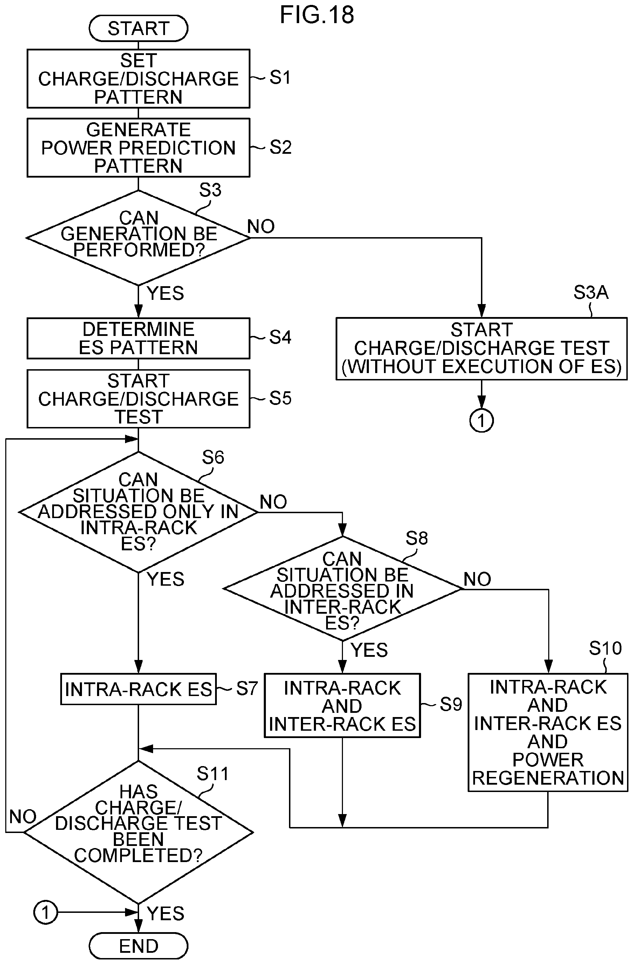

Fig. 18 is a flowchart that corresponds to a method of controlling the charge/discharge test system 10 according to this embodiment, and illustrates the flow of a charge/discharge test of the battery 28 of each ET device 20 performed by the charge/discharge test system 10.

As illustrated in Fig. 18, an operator performs, through the setting unit 18 (e.g., operation unit 18b), a setting operation of charge/discharge patterns of all or some of the test batteries 28-1 that are targets of the charge/discharge test for each ET device 20 first. In this manner, a setting command for the charge/discharge pattern set for the test battery 28-1 of each ET device 20 is input from the setting unit 18 to the converter control unit 40 of each ET device 20 through the integrated control unit 50. As a result, the charge/discharge pattern is set for each testing converter 30a in each ET device 20 (Step S1, corresponding to the setting step).

Once the setting of the charge/discharge pattern is performed, the monitoring/prediction unit 42 of each ET device 20 generates prediction power information for each testing converter 30a and outputs the prediction power information to the integrated control unit 50. Also, the detection unit 31 of each two-way DC/DC converter 30 of each ET device 20 starts to detect current power information of each test battery 28-1 or each auxiliary battery 28-2 and successively outputs the current power information to each monitoring/prediction unit 42. Then, the monitoring/prediction unit 42 of each ET device 20 outputs the current power information on each two-way DC/DC converter 30 to the integrated control unit 50. In this manner, the current power information and the prediction power information on each two-way DC/DC converter 30 of each ET device 20 are input from the integrated control unit 50 to the setting unit 18, and the current power information and the prediction power information on each two-way DC/DC converter 30 of each ET device 20 are displayed on the setting unit 18 (e.g., the display unit 18c).

Also, the pattern prediction unit 44 generates the power prediction pattern SP illustrated in Fig. 6, which has already been described above, based on the charge/discharge pattern of each test battery 28-1 with respect to each testing converter 30a (Step S2, corresponding to the prediction step). Note that in a case in which it is difficult to generate the power prediction pattern SP (NO in Step S3), the charge/discharge tests of the test batteries 28-1 are started without execution of the ES, and all the discharge power discharged from the test batteries 28-1 are subjected to the power regeneration at the two-way AC/DC converter 12 (Step S3A).

Once the power prediction pattern SP is generated (YES in Step S3), the pattern determination unit 46 determines the ES pattern IP by inverting the charging and the discharging in the power prediction pattern SP as illustrated in Fig. 6, which has already been described above (Step S4).

Next, the converter control unit 40 of each ET device 20 starts the charge/discharge test in which charging and discharging of each test battery 28-1 are performed in accordance with the corresponding charge/discharge pattern set in advance for each test battery 28-1 for each testing converter 30a (Step S5).

At this time, the converter control unit 40 of each ET device 20 executes only the intra-rack ES (ES between test batteries, or ES between test batteries and auxiliary batteries) for a case that can be addressed only by the intra-rack ES (YES in Step S6), that is, a case in which the excess power EX and the insufficient power LA do not occur, based on the ES pattern IP determined by the pattern determination unit 46 (Step S7). Specifically, each converter control unit 40 performs the ES between test batteries between mutually different test batteries 28-1 inside the same thermostatic chamber 26 based on the charge/discharge pattern of each test battery 28-1 of each testing converter 30a as illustrated in Figs. 7 to 9, which have already been described above. Also, each converter control unit 40 controls charging and discharging of the auxiliary batteries 28-2 performed by the extra converters 30b based on the ES pattern IP and executes the ES between test batteries and auxiliary batteries that is between the test batteries 28-1 and the auxiliary batteries 28-2 in the same thermostatic chamber 26. In this manner, it is possible to realize the intra-rack ES while causing the facilities to work at 100% and thereby to improve facility working rate, by connecting the user's extra auxiliary batteries 28-2 to the extra converters 30b and executing the ES between test batteries and auxiliary batteries.

On the other hand, the converter control unit 40 of each ET device 20 outputs the excess power information C1 or the insufficient power information C2 to the integrated control unit 50 for a case that is determined not to be able to be addressed only by the intra-rack ES (NO in Step S6), that is, a case in which the excess power EX or the insufficient power LA occurs, based on the ES pattern IP.

Then, the integrated control unit 50 searches for other ET devices 20 capable of addressing the inter-rack ES, that is, other ET devices 20 capable of performing charging with the excess power EX or other ET devices 20 capable of outputting the insufficient power LA with reference to the current power information, the power prediction pattern SP, and the like of each ET device 20 based on the excess power information C1 or the insufficient power information C2 input from the converter control unit 40.

In a case in which charging with all the excess power EX can be performed in the inter-rack ES (YES in Step S8), and the number of ET devices 20 capable of performing charging with the excess power EX is one, the integrated control unit 50 determines the ET device 20 as an output destination of the excess power EX. Also, in a case in which the number of ET devices 20 capable of outputting the insufficient power LA is one, the integrated control unit 50 determines the ET device 20 as an output source of the insufficient power LA.

Moreover, in a case in which the integrated control unit 50 has searched for a plurality of ET devices 20 capable of performing charging with the excess power EX or a plurality of ET devices 20 capable of outputting the insufficient power LA, the priority determination unit 52 performs determination of priority as illustrated in Fig. 13, which has already been described above. Then, the integrated control unit 50 determines the ET devices 20 as output destinations of the excess power EX or determines the ET devices 20 as output sources of the insufficient power LA in accordance with the priority. In this manner, the ET devices 20 at positions closer to the transmission source of the excess power information C1 are determined as output destinations of the excess power EX with higher priority, and the ET devices 20 at distance closer to the ET device 20 that is a transmission source of the insufficient power information C2 are determined as the ET devices 20 that are output sources of the insufficient power LA with higher priority. As a result, a loss of the excess power EX or the insufficient power LA can be reduced.

Next, the integrated control unit 50 outputs the first output destination information D1 or the second output destination information D2 to the converter control units 40 of all the ET devices 20 determined as the ET devices 20 that are the output destinations of the excess power EX or the ET devices 20 that are the output sources of the insufficient power LA. In this manner, the converter control units 40 of all the ET devices 20 that have received an input of the first output destination information D1 or the second output destination information D2 control at least one two-way DC/DC converter 30 (testing converter 30a and/or extra converter 30b) and output the excess power EX or the insufficient power LA to the ET devices 20 indicated by the first output destination information D1 or the second output destination information D2. As a result, the inter-rack ES of performing the charging with the excess power EX or covering the insufficient power LA across the plurality of ET devices 20 is performed in parallel with the intra-rack ES for each ET device 20 as illustrated in Figs. 11, 12, 14, 15 and 16, which have already been described above (Step S9).

On the other hand, in a case in which an extra part of the excess power EX that exceeds charge capacity of both the intra-rack ES and the inter-rack ES occurs (NO in Step S8), the integrated control unit 50 outputs the regeneration command D3 to the converter control unit 40 that is the transmission source of the excess power information C1. The converter control unit 40 that has received the regeneration command D3 controls at least one testing converters 30a and outputs the extra part of the excess power EX to the two-way AC/DC converter 12.

Then, the two-way AC/DC converter 12 executes power regeneration of converting the extra part of the excess power EX input from at least one testing converters 30a into regenerative power and then returning the regenerative power to the AC power source 24. In this manner, the power regeneration of the extra part of the excess power EX is performed in parallel with the intra-rack ES and the inter-rack ES (Step S10). Although the power utilization efficiency is degraded as compared with that of the ES, the degradation of the power utilization efficiency is curbed by performing the power regeneration only on the extra part of the excess power EX in the present embodiment.

Thereafter, the processing following the flow form Step S6 to Step S10 is repeatedly executed until the charge/discharge tests are completed (Step S11).

As described above, according to this embodiment, it is not necessary to perform schedule adjustment for the charge/discharge test of the test battery 28-1 for each testing converter 30a, by generating the power prediction pattern SP based on the charge/discharge patterns of each test battery 28-1 for each testing converter 30a and performing the intra-rack ES using the auxiliary battery 28-2 in accordance with the ES pattern IP determined based on the power prediction pattern SP. As a result, it is possible to perform the ES while successively performing the charge/discharge test on each test battery 28-1. It is thus possible to realize both an improvement in power utilization efficiency and securing of continuity of the charge/discharge tests (evaluation).

Also, according to the present embodiment, it is possible to further improve the power utilization efficiency by performing the inter-rack ES in a case in which the excess power EX and the insufficient power LA that cannot be addressed by the intra-rack ES occur. Moreover, according to the present embodiment, even if an extra part of the excess power EX that exceeds charge capacity of both the intra-rack ES and the inter-rack ES occurs, it is possible to perform power regeneration on the extra part.

### Others

Although each ET device 20 is provided with the ET control unit 32 in the aforementioned embodiment, each ET control unit 32 may be provided out of the ET device 20.

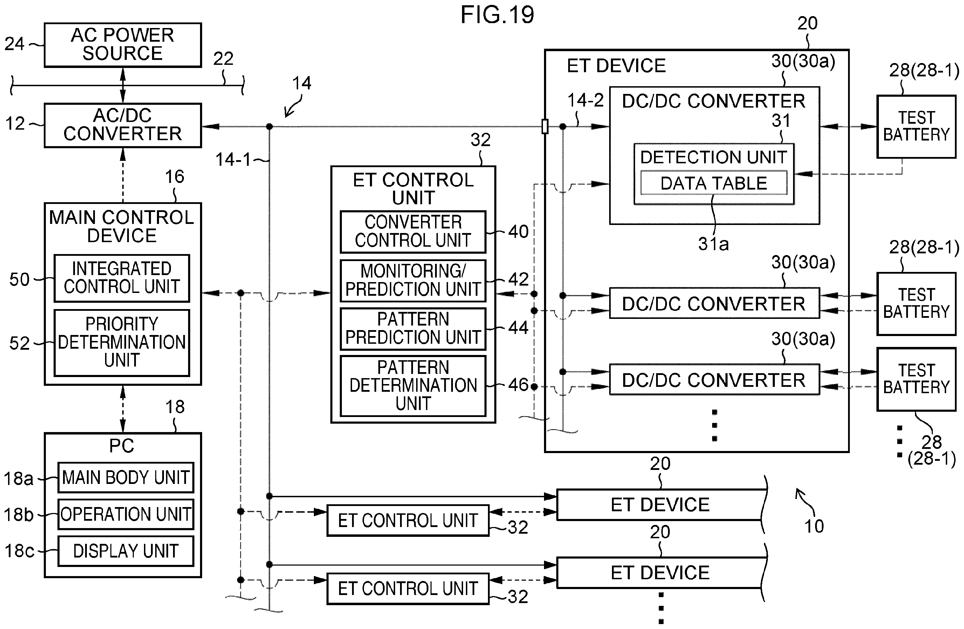

Fig. 19 is a block diagram illustrating the configuration examples of the ET devices 20 and the main control device 16 according to a modified example. For example, as illustrated in Fig. 19, the charge/discharge test system includes the ET control units 32 and the ET devices 20 as separate components. In the example illustrated in Fig. 19, the ET control units 32 are connected to the respective ET devices 20. For example, the ET control unit 32 may be physically connected to the corresponding ET device 20 by wire or the like, or may be configured to be connectable to the corresponding ET device 20 by communication or the like. The function of each ET control unit 32 may be included in the main control device 16. The function of the main control device 16 may be included in the main body unit 18a of the setting unit 18.

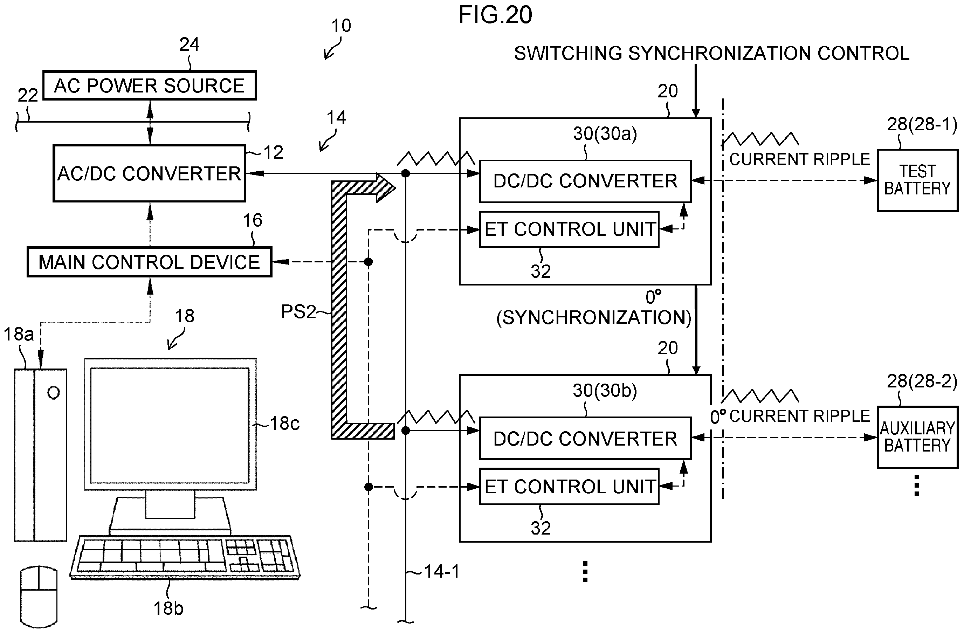

Fig. 20 is a schematic diagram illustrating an example of a switching control method between a plurality of two-way DC/DC converters 30 according to a modified example. In Fig. 20, only components required for description are illustrated, and illustration of the thermostatic chambers 26 is omitted.

In the example illustrated in Fig. 20, each ET device 20 includes one two-way DC/DC converter 30. Each battery 28 is connected to the corresponding two-way DC/DC converter 30.

The converter control unit 40 can synchronize switching control of charging and discharging between one two-way DC/DC converter 30 in a predetermined ET device 20 and one two-way DC/DC converter 30 of another ET device 20 different from the predetermined ET device 20. Note that the converter control unit 40 may synchronize switching control of charging and discharging between one two-way DC/DC converter 30 in the predetermined ET device 20 and one two-way DC/DC converter 30 of the other ET device 20 different from the predetermined ET device 20 in accordance with a command of the main control device 16.

In the example illustrated in Fig. 20, the converter control unit 40 controls discharging of one auxiliary battery 28-2 by one extra converter 30b in the predetermined ET device 20, and charges one test battery 28-1 with the discharge power discharged from one auxiliary battery 28-2 in the other ET device 20 via the testing converter 30a. At this time, the converter control unit 40 synchronizes switching control of discharging of one auxiliary battery 28-2 by one extra converter 30b in a predetermined ET device 20 with switching control of charging of one test battery 28-1 by one testing converter 30a. It is thus possible to synchronize the current ripple of current discharged by one auxiliary battery 28-2 in the predetermined ET device 20 with the current ripple of current with which one test battery 28-1 in the other ET device 20 is charged, by synchronizing switching control of discharging of one auxiliary battery 28-2 by one extra converter 30b in the predetermined ET device 20 with switching control of charging of one test battery 28-1 by one testing converter 30a in the other ET device 20. It is thus possible to reduce the output current ripple by synchronizing switching control of discharging of one auxiliary battery 28-2 by one extra converter 30b in the predetermined ET device 20 with switching control of charging of one test battery 28-1 by one testing converter 30a in the other ET device 20. By reducing the output current ripple, reduction in loss, reduction in cable heat generation, and long operating lives of fuses can be achieved.

Although the number of two-way AC/DC converters 12 is one in the aforementioned embodiment, a plurality of two-way AC/DC converters 12 may be provided.

Although the batteries have been exemplified and described as the charging/discharging objects in the aforementioned embodiment, the charging targets are not particularly limited as long as the charging targets can be targets of charge/discharge tests, such as a motor including capacitors and power converters.

Examples of the charge/discharge test system and the method of controlling the charge/discharge test system that are obtained from the configuration disclosed in this Description are described below as a supplement.
(1) A charge/discharge test system includes:
   a two-way AC/DC converter that has one end connected to an alternating current power source and another end connected to a DC bus; and
   at least one charge/discharge test device that includes a plurality of two-way DC/DC converters, each of which has one end connected to the DC bus and another end connected to a charging target among charging targets that are different from each other, and a converter control unit that controls charging and discharging of the charging target of each of the two-way DC/DC converters, and
   the plurality of two-way DC/DC converters include one or a plurality of converters in use connected to a sample that is the charging target as a target of a charge/discharge test and one or a plurality of converters not in use connected to an auxiliary battery that is the charging target other than the target of the charge/discharge test,
   the charge/discharge test system further includes:
      a setting unit that is capable of setting a charge/discharge pattern of the sample for each converter in use, and
      a prediction unit that generates a power prediction pattern indicating a temporal change in a total value of charge and discharge power of all the converters in use inside the charge/discharge test device based on the charge/discharge pattern set by the setting unit, and
      in a case in which the converters in use execute the charging and the discharging of the sample in accordance with the charge/discharge pattern, the converter control unit controls charging and discharging of the auxiliary battery performed by the converters not in use based on the power prediction pattern generated by the prediction unit, causes the auxiliary battery to be charged with discharge power output from the converters in use that perform the discharging of the sample, and causes the auxiliary battery to output charge power, with which the auxiliary battery has been charged, to the converters in use that perform the charging of the sample, via the DC bus.
(2) The charge/discharge test system according to (1) is configured such that:
   the at least one charge/discharge test device includes a plurality of charge/discharge test devices,
   the charge/discharge test system includes an integrated control unit that performs integrated control on the converter control unit of each of the charge/discharge test devices,
   in a case in which the discharge power exceeding a chargeable capacity of the auxiliary battery is generated, the converter control unit outputs excess power information indicating an amount of excess power exceeding the chargeable capacity in the discharge power to the integrated control unit,
   the integrated control unit receives an input of the excess power information and outputs, to a transmission source of the excess power information, first output destination information indicating another one of the charge/discharge test devices capable of charging the charging target with the excess power,
   the transmission source of the excess power information that has received an input of the first output destination information controls one or a plurality of the two-way DC/DC converters and outputs the excess power to the charge/discharge test device corresponding to the first output destination information, and
   the converter control unit of the charge/discharge test device that has received an input of the excess power causes one or a plurality of the charging targets to be charged with the excess power.
(3) The charge/discharge test system according to (2) is configured such that,
   in a case in which the plurality of charge/discharge test devices capable of performing charging with the excess power are present, the integrated control unit determines, as an output destination of the excess power, the charge/discharge test device at a position closer to the transmission source of the excess power information with higher priority and outputs the first output destination information indicating the output destination of the excess power to the transmission source of the excess power information.
(4) The charge/discharge test system according to (2) or (3) is configured such that:
   in a case in which the charge/discharge test device capable of performing charging with the excess power is not present, the integrated control unit outputs a regeneration command for commanding the transmission source of the excess power information to output the excess power to the two-way AC/DC converter,
   the transmission source of the excess power information outputs the excess power to the two-way AC/DC converter based on the regeneration command, and
   the two-way AC/DC converter converts the excess power into AC power and outputs the AC power to the alternating current power source.
(5) The charge/discharge test system according to any one of (1) to (4) is configured such that:
   the at least one charge/discharge test device includes a plurality of charge/discharge test devices,
   the charge/discharge test system includes an integrated control unit that performs integrated control on the converter control unit of each of the charge/discharge test devices,
   in a case in which charge power of the auxiliary battery is insufficient as compared with power necessary to charge the sample, the converter control unit outputs insufficient power information indicating an amount of insufficient power that is insufficient to charge the sample to the integrated control unit,
   the integrated control unit receives an input of the insufficient power information and outputs, to the converter control unit of another one of the charge/discharge test devices capable of outputting the insufficient power, second output destination information indicating the charge/discharge test device that is a transmission source of the insufficient power information as an output destination of the insufficient power,
   the converter control unit that has received an input of the second output destination information controls one or a plurality of the two-way DC/DC converters and causes the one or plurality of two-way DC/DC converters to output the insufficient power to the charge/discharge test device corresponding to the second output destination information, and
   the converter control unit of the charge/discharge test device that has received an input of the insufficient power causes one or a plurality of the samples to be charged with the insufficient power.
(6) The charge/discharge test system according to (5) is configured such that,
   in a case in which a plurality of other charge/discharge test devices capable of outputting the insufficient power are present, the integrated control unit determines, as an output source of the insufficient power, the charge/discharge test device at a position closer to the transmission source of the insufficient power information with higher priority and outputs the second output destination information to the output source of the insufficient power.
(7) The charge/discharge test system according to any one of (1) to (6) is configured such that a number of the two-way AC/DC converters is one.
(8) The charge/discharge test system according to any one of (1) to (7), further includes
   a detection unit that successively detects the charge power and the discharge power at present of each two-way AC/DC converter.
(9) In a method of controlling a charge/discharge test system, the charge/discharge test system includes:
   a two-way AC/DC converter that has one end connected to an alternating current power source and another end connected to a DC bus, and
   at least one charge/discharge test device that includes a plurality of two-way DC/DC converters, each of which has one end connected to the DC bus and another end connected to a charging target among charging targets that are different from each other, and a converter control unit that controls charging and discharging of the charging target of each of the two-way DC/DC converters,
   the plurality of two-way DC/DC converters including one or a plurality of converters in use that are connected to a sample that is the charging target as a target of a charge/discharge test and one or a plurality of converters not in use that are connected to an auxiliary battery that is the charging target other than the target of the charge/discharge test, and
   the method includes:
      setting a charge/discharge pattern of the sample for each of the converters in use; and
      performing prediction through generating of a power prediction pattern indicating a temporal change in a total value of charge and discharge power of all the converters in use inside the charge/discharge test device based on the charge/discharge pattern set in the setting, and
      in a case in which the converters in use execute the charging and the discharging of the sample in accordance with the charge/discharge pattern, the converter control unit controls charging and discharging of the auxiliary battery performed by the converters not in use based on the power prediction pattern generated in the prediction, causes the auxiliary battery to be charged with discharge power output from the converters in use that perform the discharging of the sample, and causes the auxiliary battery to output charge power, with which the auxiliary battery has been charged, to the converters in use that perform the charging of the sample, via the DC bus.

Further aspects of the invention are as follows.

A first aspect of the invention is a charge/discharge test system (10), comprising:
a two-way AC/DC converter (12) that has one end connected to an alternating current power source (24) via an AC bus (22), and another end connected to a first DC bus (14-1);
characterized in that the charge/discharge test system (10) comprises:
   a first charge/discharge test device (20) that includes a second DC bus (14-2) connected to the first DC bus (14-1), a plurality of first two-way DC/DC converters (30), each of which has one end connected to the second DC bus (14-2) and another end connected to a first charging/discharging object (28, 28-1, 28-2) among a plurality of first charging/discharging objects (28, 28-1, 28-2), and a first converter control unit (40) that controls charging and discharging of the plurality of first charging/discharging objects (28, 28-1, 28-2);
   a setting unit (18) that sets at least one charge/discharge pattern (P1, P2) corresponding to at least one test charging/discharging object (28-1) serving as a target of a charge/discharge test among the first charging/discharging objects (28, 28-1, 28-2); and
   a prediction unit (44) that generates a power prediction pattern (SP) indicating a temporal change in a total value of charge and discharge power of at least one testing converter (30a) corresponding to the at least one test charging/discharging object (28-1) in the first two-way DC/DC converters (30), based on the at least one charge/discharge pattern (P1, P2),
   wherein the first converter control unit (40) controls charging and discharging of the first charging/discharging objects (28, 28-1, 28-2) by the first two-way DC/DC converters (30), based on the at least one charge/discharge pattern (P1, P2) and on the power prediction pattern (SP).

In a second aspect of the invention, the charge/discharge test system (10) according to the aforementioned aspect, wherein in a case in which the at least one testing converter (30a) executes the charging and discharging of the at least one test charging/discharging object (28-1) in accordance with the at least one charge/discharge pattern (P1, P2), the first converter control unit (40) controls the charging and discharging of at least one auxiliary charging/discharging object (28-2) different from the at least one test charging/discharging object (28-1) performed by at least one extra converter (30b) different from the at least one testing converter (30a) among the first two-way DC/DC converters (30), based on the power prediction pattern (SP).

In a third aspect of the invention the charge/discharge test system (10) according to previous aspect, wherein the first converter control unit (40) charges the at least one auxiliary charging/discharging object (28-2), via the at least one extra converter (30b), with power output via the second DC bus (14-2) from the at least one testing converter (30a), and charges the at least one test charging/discharging object (28-1), via the at least one testing converter (30a), with power output from the at least one extra converter (30b).

In a fourth aspect, the charge/discharge test system (10) according to any one of described previous three aspects, further comprising:
a second charge/discharge test device (20) that includes a third DC bus (14-2) connected to the first DC bus (14-1), a plurality of second two-way DC/DC converters (30), each of which has one end connected to the third DC bus (14-2) and another end connected to a second charging/discharging object (28, 28-1, 28-2) among a plurality of second charging/discharging objects (28, 28-1, 28-2), and a second converter control unit (40) that controls charging and discharging of the plurality of second charging/discharging objects (28, 28-1, 28-2);
a third charge/discharge test device (20) that includes a fourth DC bus (14-2) connected to the first DC bus (14-1), a plurality of third two-way DC/DC converters (30), each of which has one end connected to the fourth DC bus (14-2) and another end connected to a third charging/discharging object (28, 28-1, 28-2) among a plurality of third charging/discharging objects (28, 28-1, 28-2), and a third converter control unit (40) that controls charging and discharging of the plurality of third charging/discharging objects (28, 28-1, 28-2); and
an integrated control unit (50) that integrally controls the first converter control unit (40), the second converter control unit (40), and the third converter control unit (40),
wherein the first converter control unit (40) outputs power to the second charge/discharge test device (20) and the third charge/discharge test device (20) via the first DC bus (14-1) in accordance with control by the integrated control unit (50),
the second converter control unit (40) outputs power to the first charge/discharge test device (20) and the third charge/discharge test device (20) via the first DC bus (14-1) in accordance with control by the integrated control unit (50), and
the third converter control unit (40) outputs power to the first charge/discharge test device (20) and the second charge/discharge test device (20) via the first DC bus (14-1) in accordance with control by the integrated control unit (50).

A fifth aspect of the invention is a charge/discharge test system (10) according to the fourth aspect, wherein in a case in which extra power exceeding a chargeable capacity of the first charging/discharging objects (28, 28-1, 28-2) is generated, the first converter control unit (40) outputs, to the integrated control unit (50), excess power information (C1) indicating excess power exceeding the chargeable capacity in the extra power.

In a sixth aspect of the invention, the charge/discharge test system (10) according to the previous aspect,
wherein the integrated control unit (50) receives the excess power information (C1) and outputs, to the first charge/discharge test device (20), output destination information (D1) indicating the second charge/discharge test device (20) capable of charging with the excess power, and
the first converter control unit (40) outputs the excess power to the second charge/discharge test device (20) via the first DC bus (14-1), based on the excess power information (C1).

In a seventh aspect, the charge/discharge test system (10) according to the fifth aspect of the invention,
wherein in a case in which the second charge/discharge test device (20) and the third charge/discharge test device (20) are chargeable with the excess power when the excess power information (C1) is received, the integrated control unit (50) determines the second charge/discharge test device (20) disposed at a distance close to the first charge/discharge test device (20), as an output destination of the excess power, and outputs, to the first converter control unit (40), output destination information (D1) indicating the second charge/discharge test device (20) chargeable with the excess power, and
the first converter control unit (40) outputs the excess power to the second charge/discharge test device (20) via the first DC bus (14-1), based on the excess power information (C1) and on the output destination information (D1).

In an eighth aspect, the charge/discharge test system (10) according to the fifth aspect of the invention,
wherein in a case in which the second charge/discharge test device (20) and the third charge/discharge test device (20) are not chargeable with the excess power, the integrated control unit (50) outputs, to the first charge/discharge test device (20), a regeneration command (D3) for commanding output of the excess power to the two-way AC/DC converter (12),
the first charge/discharge test device (20) outputs the excess power to the two-way AC/DC converter (12), based on the regeneration command (D3), and
the two-way AC/DC converter (12) converts the excess power into AC power and outputs the AC power to the alternating current power source (24).

According to a ninth aspect of the invention, the charge/discharge test system (10) according to the fourth aspect, wherein in a case in which there is a lack of insufficient power required to charge the first charging/discharging objects (28, 28-1, 28-2), the first converter control unit (40) outputs, to the integrated control unit (50), insufficient power information (C2) indicating an amount of power insufficient in the first charging/discharging objects (28, 28-1, 28-2).

In a tenth aspect, the charge/discharge test system (10) according to the previously described ninth aspect,
wherein the integrated control unit (50) receives the insufficient power information (C2), and outputs output destination information (D2) indicating the first charge/discharge test device (20) lacking in the insufficient power, to the second charge/discharge test device (20) capable of outputting the insufficient power, and
the second converter control unit (40) outputs the insufficient power to the first charge/discharge test device (20) via the first DC bus (14-1), based on the insufficient power information (C2).

In an eleventh aspect, the charge/discharge test system (10) according to the described tenth aspect,
wherein in a case in which the second charge/discharge test device (20) and the third charge/discharge test device (20) are capable of outputting the insufficient power when the insufficient power information (C2) is received, the integrated control unit (50) determines the second charge/discharge test device (20) disposed at a distance close to the first charge/discharge test device (20), as an output source, and outputs, to the second converter control unit (20), the output destination information (D2) indicating the first charge/discharge test device (20) lacking in the insufficient power, and
the second converter control unit (40) outputs the insufficient power to the first charge/discharge test device (20) via the first DC bus (14-1), based on the insufficient power information (C2) and on the output destination information (D2).

The twelfth aspect of the invention is the charge/discharge test system (10) according to the fourth aspect described previously,
wherein the first two-way DC/DC converters (30) include a plurality of first detectors (31) that detect charge power at present and discharge power at present of the first charging/discharging objects (28, 28-1, 28-2),
the second two-way DC/DC converters (30) include a plurality of second detectors (31) that detect charge power at present and discharge power at present of the second charging/discharging objects (28, 28-1, 28-2), and
the third two-way DC/DC converters (30) include a plurality of third detectors (31) that detect charge power at present and discharge power at present of the third charging/discharging objects (28, 28-1, 28-2).

A thirteenth aspect of the invention is a method of controlling a charge/discharge test system (10), the charge/discharge test system (10) comprising: a two-way AC/DC converter (12) that has one end connected to an alternating current power source (24) via an AC bus (22), and another end connected to a first DC bus (14-1); and a first charge/discharge test device (20) that includes a second DC bus (14-2) connected to the first DC bus (14-1), a plurality of first two-way DC/DC converters (30), each of which has one end connected to the second DC bus (14-2) and another end connected to a first charging/discharging object (28, 28-1, 28-2) among a plurality of first charging/discharging objects (28, 28-1, 28-2), and a first converter control unit (40) that controls charging and discharging of the plurality of first charging/discharging objects (28, 28-1, 28-2), the method comprising:
setting at least one charge/discharge pattern (P1, P2) corresponding to at least one test charging/discharging object (28-1) serving as a target of a charge/discharge test among the first charging/discharging objects (28, 28-1, 28-2);
generating a power prediction pattern (SP) indicating a temporal change in a total value of charge and discharge power of at least one testing converter (30a) corresponding to the at least one test charging/discharging object (28-1) in the first two-way DC/DC converters (30), based on the at least one charge/discharge pattern (P1, P2); and
controlling charging and discharging of the first charging/discharging objects (28, 28-1, 28-2) by the first two-way DC/DC converters (30), based on the at least one charge/discharge pattern (P1, P2) and on the power prediction pattern (SP).

### Reference Signs List:

10 Charge/discharge test system
12 Two-way AC/DC converter
14, 14-1, 14-2 DC bus
16 Main control device
18a Main body unit
18b Operation unit
18c Display unit
20 ET device
22 AC bus
24 AC power source
26 Thermostatic chamber
28 Battery
28-1 Test battery
28-2 Auxiliary battery
30 Two-way DC/DC converter
30a Testing converter
30b Extra converter
31 Detection unit
31a Data table
32 ET control unit
40 Converter control unit
42 Prediction unit
44 Pattern prediction unit
46 Pattern determination unit
50 Integrated control unit
52 Priority determination unit
AC Two-way
C1 Excess power information
C2 Insufficient power information
D1 First output destination information
D2 Second output destination information
D3 Regeneration command
EX Excess power
IP ES pattern
LA Insufficient power
P1 Pattern
P2 Pattern
SP Power prediction pattern

## Claims

1. A charge/discharge test system (10), comprising:
a two-way AC/DC converter (12) that has one end connected to an alternating current power source (24) via an AC bus (22), and another end connected to a first DC bus (14-1); and
a first charge/discharge test device (20) that includes a second DC bus (14-2) connected to the first DC bus (14-1), a plurality of first two-way DC/DC converters (30), each of which has one end connected to the second DC bus (14-2) and another end connected to a first charging/discharging object (28, 28-1, 28-2) among a plurality of first charging/discharging objects (28, 28-1, 28-2).

2. The charge/discharge test system (10) according to claim 1, further comprising
a first converter control unit (40) that controls charging and discharging of the plurality of first charging/discharging objects (28, 28-1, 28-2),
wherein the first converter control unit (40) controls charging and discharging of the first charging/discharging objects (28, 28-1, 28-2) by the first two-way DC/DC converters (30), based on at least one charge/discharge pattern (P1, P2) corresponding to at least one test charging/discharging object (28-1) serving as a target of a charge/discharge test among the first charging/discharging objects (28, 28-1, 28-2) and on t a power prediction pattern (SP) indicating a temporal change in a total value of charge and discharge power of at least one testing converter (30a) corresponding to the at least one test charging/discharging object (28-1) in the first two-way DC/DC converters (30), based on the at least one charge/discharge pattern (P1, P2).

3. The charge/discharge test system (10) according to claim 2, wherein in a case in which the at least one testing converter (30a) executes the charging and discharging of the at least one test charging/discharging object (28-1) in accordance with the at least one charge/discharge pattern (P1, P2), the first converter control unit (40) controls the charging and discharging of at least one auxiliary charging/discharging object (28-2) different from the at least one test charging/discharging object (28-1) performed by at least one extra converter (30b) different from the at least one testing converter (30a) among the first two-way DC/DC converters (30), based on the power prediction pattern (SP).

4. The charge/discharge test system (10) according to claim 3, wherein the first converter control unit (40) charges the at least one auxiliary charging/discharging object (28-2), via the at least one extra converter (30b), with power output via the second DC bus (14-2) from the at least one testing converter (30a), and charges the at least one test charging/discharging object (28-1), via the at least one testing converter (30a), with power output from the at least one extra converter (30b).

5. The charge/discharge test system (10) according to any one of claims 1 to 4, further comprising:
a second charge/discharge test device (20) that includes a third DC bus (14-2) connected to the first DC bus (14-1), a plurality of second two-way DC/DC converters (30), each of which has one end connected to the third DC bus (14-2) and another end connected to a second charging/discharging object (28, 28-1, 28-2) among a plurality of second charging/discharging objects (28, 28-1, 28-2), and a second converter control unit (40) that controls charging and discharging of the plurality of second charging/discharging objects (28, 28-1, 28-2);
a third charge/discharge test device (20) that includes a fourth DC bus (14-2) connected to the first DC bus (14-1), a plurality of third two-way DC/DC converters (30), each of which has one end connected to the fourth DC bus (14-2) and another end connected to a third charging/discharging object (28, 28-1, 28-2) among a plurality of third charging/discharging objects (28, 28-1, 28-2), and a third converter control unit (40) that controls charging and discharging of the plurality of third charging/discharging objects (28, 28-1, 28-2); and
an integrated control unit (50) that integrally controls the first converter control unit (40), the second converter control unit (40), and the third converter control unit (40),
wherein the first converter control unit (40) outputs power to the second charge/discharge test device (20) and the third charge/discharge test device (20) via the first DC bus (14-1) in accordance with control by the integrated control unit (50),
the second converter control unit (40) outputs power to the first charge/discharge test device (20) and the third charge/discharge test device (20) via the first DC bus (14-1) in accordance with control by the integrated control unit (50), and
the third converter control unit (40) outputs power to the first charge/discharge test device (20) and the second charge/discharge test device (20) via the first DC bus (14-1) in accordance with control by the integrated control unit (50).

6. The charge/discharge test system (10) according to claim 5, wherein in a case in which extra power exceeding a chargeable capacity of the first charging/discharging objects (28, 28-1, 28-2) is generated, the first converter control unit (40) outputs, to the integrated control unit (50), excess power information (C1) indicating excess power exceeding the chargeable capacity in the extra power.

7. The charge/discharge test system (10) according to claim 6,
wherein the integrated control unit (50) receives the excess power information (C1) and outputs, to the first charge/discharge test device (20), output destination information (D1) indicating the second charge/discharge test device (20) capable of charging with the excess power, and
the first converter control unit (40) outputs the excess power to the second charge/discharge test device (20) via the first DC bus (14-1), based on the excess power information (C1).

8. The charge/discharge test system (10) according to claim 6,
wherein in a case in which the second charge/discharge test device (20) and the third charge/discharge test device (20) are chargeable with the excess power when the excess power information (C1) is received, the integrated control unit (50) determines the second charge/discharge test device (20) disposed at a distance close to the first charge/discharge test device (20), as an output destination of the excess power, and outputs, to the first converter control unit (40), output destination information (D1) indicating the second charge/discharge test device (20) chargeable with the excess power, and
the first converter control unit (40) outputs the excess power to the second charge/discharge test device (20) via the first DC bus (14-1), based on the excess power information (C1) and on the output destination information (D1).

9. The charge/discharge test system (10) according to claim 6,
wherein in a case in which the second charge/discharge test device (20) and the third charge/discharge test device (20) are not chargeable with the excess power, the integrated control unit (50) outputs, to the first charge/discharge test device (20), a regeneration command (D3) for commanding output of the excess power to the two-way AC/DC converter (12),
the first charge/discharge test device (20) outputs the excess power to the two-way AC/DC converter (12), based on the regeneration command (D3), and
the two-way AC/DC converter (12) converts the excess power into AC power and outputs the AC power to the alternating current power source (24).

10. The charge/discharge test system (10) according to claim 5, wherein in a case in which there is a lack of insufficient power required to charge the first charging/discharging objects (28, 28-1, 28-2), the first converter control unit (40) outputs, to the integrated control unit (50), insufficient power information (C2) indicating an amount of power insufficient in the first charging/discharging objects (28, 28-1, 28-2).

11. The charge/discharge test system (10) according to claim 10,
wherein the integrated control unit (50) receives the insufficient power information (C2), and outputs output destination information (D2) indicating the first charge/discharge test device (20) lacking in the insufficient power, to the second charge/discharge test device (20) capable of outputting the insufficient power, and
the second converter control unit (40) outputs the insufficient power to the first charge/discharge test device (20) via the first DC bus (14-1), based on the insufficient power information (C2).

12. The charge/discharge test system (10) according to claim 11,
wherein in a case in which the second charge/discharge test device (20) and the third charge/discharge test device (20) are capable of outputting the insufficient power when the insufficient power information (C2) is received, the integrated control unit (50) determines the second charge/discharge test device (20) disposed at a distance close to the first charge/discharge test device (20), as an output source, and outputs, to the second converter control unit (20), the output destination information (D2) indicating the first charge/discharge test device (20) lacking in the insufficient power, and
the second converter control unit (40) outputs the insufficient power to the first charge/discharge test device (20) via the first DC bus (14-1), based on the insufficient power information (C2) and on the output destination information (D2).

13. A method of controlling a charge/discharge test system (10), the charge/discharge test system (10) comprising: a two-way AC/DC converter (12) that has one end connected to an alternating current power source (24) via an AC bus (22), and another end connected to a first DC bus (14-1); and a first charge/discharge test device (20) that includes a second DC bus (14-2) connected to the first DC bus (14-1), a plurality of first two-way DC/DC converters (30), each of which has one end connected to the second DC bus (14-2) and another end connected to a first charging/discharging object (28, 28-1, 28-2) among a plurality of first charging/discharging objects (28, 28-1, 28-2), and a first converter control unit (40) that controls charging and discharging of the plurality of first charging/discharging objects (28, 28-1, 28-2), the method comprising
controlling charging and discharging of the first charging/discharging objects (28, 28-1, 28-2) by the first two-way DC/DC converters (30), based on at least one charge/discharge pattern (P1, P2) corresponding to at least one test charging/discharging object (28-1) serving as a target of a charge/discharge test among the first charging/discharging objects (28, 28-1, 28-2) and on a power prediction pattern (SP) indicating a temporal change in a total value of charge and discharge power of at least one testing converter (30a) corresponding to the at least one test charging/discharging object (28-1) in the first two-way DC/DC converters (30), based on the at least one charge/discharge pattern (P1, P2).
